Europäisches Patentamt

European Patent Office

Office européen des brevets

(19)

(11) **EP 0 473 096 B1**

(12) **EUROPEAN PATENT SPECIFICATION**

(45) Date of publication and mention
of the grant of the patent:
**26.02.1997 Bulletin 1997/09**

(51) Int Cl.$^6$: **H03H 9/145**, H03H 9/02

(21) Application number: **91114286.7**

(22) Date of filing: **26.08.1991**

(54) **Station for digital communication system and surface acoustic wave module**

Station für digitales Nachrichtensystem und akustisches Oberflächenwellenmodul

Station pour système de communication numérique et module à ondes acoustiques de surface

(84) Designated Contracting States:
**DE GB**

(30) Priority: **27.08.1990 JP 224953/90**
**15.02.1991 JP 21798/91**

(43) Date of publication of application:
**04.03.1992 Bulletin 1992/10**

(73) Proprietor: **HITACHI, LTD.**
**Chiyoda-ku, Tokyo 101 (JP)**

(72) Inventors:
 • **Nogami, Hiroshi**
   **Chigasaki-shi (JP)**
 • **Shiba, Takashi**
   **Yokosuka-shi (JP)**
 • **Buma, Takemitsu**
   **522, Toyotacho, Toyota-shi (JP)**
 • **Hikino, Osamu**
   **5981, Tsujido, Fujisawa-shi (JP)**
 • **Sudo, Shigeyuki**
   **5977-1, Tsujido, Fujisawa-shi (JP)**

(74) Representative: **Altenburg, Udo, Dipl.-Phys. et al**
**Patent- und Rechtsanwälte**
**Bardehle . Pagenberg . Dost . Altenburg .**
**Frohwitter . Geissler & Partner,**
**Postfach 86 06 20**
**81633 München (DE)**

(56) References cited:
**DE-A- 3 618 913**

 • **ULTRASONICS SYMPOSIUM PROCEEDINGS
   1983 vol. 1, October 1983, ATLANTA US pages
   53 - 58; GAUTAM: 'Application of SAW filters
   using UDTs in short distance communication
   systems'**
 • **JAPANESE JOURNAL OF APPLIED PHYSICS,
   SUPPLEMENTS. vol. 22, no. 3, 1983, TOKYO JA
   pages 12 - 15; URABE: 'SAW device application
   to public telecommunication system in Japan'**
 • **PATENT ABSTRACTS OF JAPAN vol. 03, no. 36
   (E-100) & JP-A-54 014 137**
 • **JAPANESE JOURNAL OF APPLIED PHYSICS,
   SUPPLEMENTS. vol. 26, no. 1, 1987, TOKYO JA
   pages 132 - 134; FUJITA ET AL: 'A new
   unidirectional SAW transducer with a simplified
   external network'**

**Description**

BACKGROUND OF THE INVENTION

The present invention relates to a station for digital communication system and a surface acoustic wave module, or more in particular to a mobile station for digital communication system using a surface acoustic filter having a unidirectional transducer for reducing the transmission distortion and the loss of a radio frequency (RF) circuit or an intermediate frequency (IF) circuit and at the same time improving the stability of a voltage-controlled oscillator in a frequency synthesizer circuit, and a surface acoustic wave module including a unidirectional transducer preferable for reducing the insertion loss as a surface acoustic wave filter.

An automobile telephone in Japan, as disclosed in Electronic Techniques, May 1988, pp. 52 to 59, for example, uses an FSK (frequency shift keying) system in which the mobile station has a frequency range of 925 to 940 MHz and the base station 870 to 885 MHz, with 600 channels having a channel interval of 25 kHz, a maximum frequency deviation of ±5 kHz for audio signal, and a transmission rate of 0.3 kbits/sec using Manchester code and maximum frequency of ±4.5 kHz for data signal.

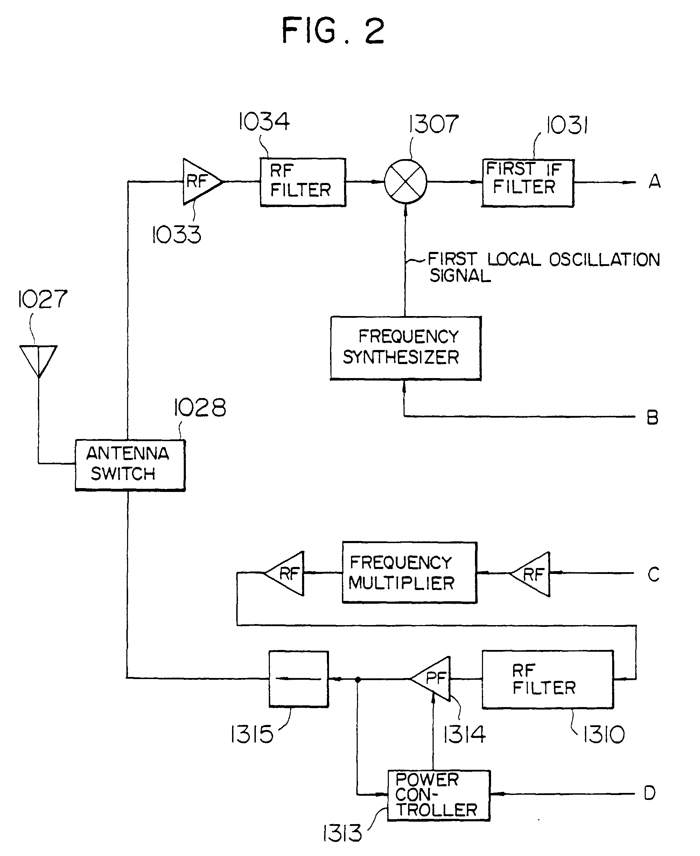

Fig. 2 is a block diagram showing a radio frequency and an intermediate frequency circuit portions of an automobile telephone in Japan.

In Fig. 2, in receiving mode, the signal from an antenna 1027, with the unrequired waves suppressed by an RF filter 1034 through an antenna switch 1028 and a radio frequency amplifier 1033, is subsequently mixed with a first-station local oscillation frequency signal (first-station transmitted signal) at a mixer 1307 and converted into a first intermediate frequency signal (first IF signal).

The first IF filter (first intermediate frequency filter) 1031 extracts with a bandwidth of 25 kHz and sends to subsequent circuits a signal of, say, 94.35 MHz or 88.5 MHz as a first IF signal.

Also, the first-station transmitted signal is normally generated by a frequency synthesizer including a voltage-controlled oscillator (VCO).

In transmitting mode, on the other hand, the VCO frequency of the other synthesizers is modulated by an input signal including an audio signal or a data. This signal is applied by way of a terminal C and, through the RF (radio frequency, high frequency) amplifier, a frequency multiplier, etc., is filtered by an RF filter 1310 of an intermediate frequency of 925 to 940 MHz. The resulting signal is further applied to the antenna 1027 by an antenna switch 1028 through a power amplifier 1314 and an isolator 1315.

A conventional surface acoustic wave module used for the IF filter or the like is described in "Impulse Model Design of Acoustic Surface-Wave Filters", Clinton S. Hartmann et al, IEEE, Trans. on Microwave Theory and Techniques, Vol. MTT-21, No.4, April 1973, pp.162 to 175.

Also, a unidirectional transducer is described, for example, in "A Collection of Lectures 1-5-4" by Japan Acoustics Society (October 1976). This reference deals with a system configured of an electrical phase shifter including a resistor and an inductor with the geometric phase difference of an odd-numbered multiple of $\pi/2$ in radians between transducers and the surface acoustic wave propagated in a direction.

A unidirectional transducer is described more specifically, for instance, in the Journal of the Acoustic Society of Japan, Vol.33, No.10, Oct. 1977, pp.532 to 539 and also in DE-A-36 18 913. The latter document shows a SAW sytem having sending and reflecting electrodes which are interconnected by a phase shifter having pure reactance elements.

SUMMARY OF THE INVENTION

The above-mentioned conventional system employs a modem system for analog signals. For maintaining the performance by broadening the band in such a manner as to permit transmission and receiving of a signal under the digital system (GSM: Group Special Mobile), DECT system or British CT2 system being studied in Europe, for example, the problem described below is posed.

In the GSM system, a signal is transmitted in a band of 900 MHz (receiving frequency of base station: 890 to 915 MHz, transmission frequency thereof: 935 to 960 MHz) with the channel interval of 200 kHz and a multiple (8) channel TDMA (time-division multiple access), a GMSK (Gaussian Minimum Shift Keying) modulation system of 270.833 kbits/sec and an audio coding by RPE-LTP (Regular Pulse Excitation - Long Term Prediction).

In the above-mentioned station for digital communication system, the filter characteristics of intermediate- and radio-frequency circuits are different conspicuously from those of an analog system providing an automobile telephone system in Japan. As an example, the first IF filter of the analog system has a pass band of approximately 25 kHz, whereas the pass band of the digital system is widened by a factor of about eight with much stricter specifications of the phase characteristics and a group delay deviation of the filter element. With the worsening of the phase characteristics and the group delay characteristics, the error rate of the digital signal is deteriorated.

As a result, a quartz filter used with a conventional analog system, which is incapable of securing a bandwidth and also has an excessive phase distortion, is incapable of being used with a digitized system.

Further, a voltage-controlled oscillator (VCO) used with the station for digital communication system described above is required to have a frequency range much wider, a phase noise much smaller and an oscillation resistance much higher than the analog system.

It is an object of the present invention to provide a compact station for digital communication system superior in performance with the above-mentioned problem obviated by a surface acoustic wave module of low insertion loss satisfying the above-mentioned phase and group delay characteristics.

In a surface acoustic wave module, unidirectional transducers or group-type unidirectional transducers using a single independent signal source and a phase shifter element for propagating a surface acoustic wave in a direction are well known with a geometric phase difference of $\pi/2$ (or an odd-numbered multiple of $\pi/2$) between transducers.

Further, a conventionally well-known configuration with a geometric phase difference of $\pi/2$ (or an odd-numbered multiple of $\pi/2$) between transducers is incapable of propagating the surface acoustic wave in exactly a single direction in satisfactory manner.

Also, JP-A-64-27306 discloses a surface acoustic wave filter using only a capacitive element as a phase shifter for securing an electrical phase difference and having a specified configuration of an electrode.

Further, a surface acoustic wave module disclosed in JP-A-63-131710 is so configured that the Q electrode has a conductance different from the I electrode and the geometric phase difference determined by the center distance between the electrodes is displaced from an odd-numbered multiple of $\pi/2$.

The problem of these conventional systems, however, is that since the electrodes are configured in a specific manner, the transducer configuration is limited in designing a surface acoustic wave module.

Another object of the present invention is to provide a surface acoustic wave module in which the transducers are not configured in a specific manner unlike in the conventional systems, and even when the geometric phase difference between transducers is not an integral multiple of $\pi/2$, the surface acoustic wave is propagated in exactly a single direction thereby to reduce the insertion loss.

Also, in a unidirectional electrode or a group-type unidirectional transducer, the advantage is improved in terms of productivity and cost with the decrease in the number of electrical phase shifters required for propagating the surface acoustic wave in a direction.

Still another object of the present invention is to provide a surface acoustic wave module capable of propagating a surface acoustic wave in exactly a single direction by an electrical phase shifter having a single component element.

The above objects are achieved by a surface acoustic wave module having the features of claim 1 and by a station for a digital communications system according to claim 11. Advantageous embodiments are defined in the dependent claims.

A surface acoustic wave filter having unidirectional transducers is arranged in a radio frequency circuit and/or an intermediate frequency circuit in a transmitting-receiving circuit, and further a surface acosutic wave element is inserted in a resonance circuit of a voltage-controlled oscillator in the frequency synthesized circuit.

The unidirectional transducer referred to above is of such a type that the power of the surface acoustic waves in forward and reverse directions transmitted from the transducer are unbalanced.

The surface acoustic wave element is accommodated in a surface-mount type package capable of being soldered directly to a printed board by a plane electrode.

Also, the characteristics of the surface acoustic wave element used for the station for digital mobile communication system are adapted to the GSM or DECT system of automobile telephone in Europe or the CT2 system of cordless telephone in the Britain.

In an embodiment of the invention, there is provided a surface acoustic wave module comprising a plurality of interdigital transducers on a piezoelectric substrate for transmitting and receiving a surface acoustic wave, at least one of the transducers including a unidirectional transducer including a combination of a transmitting electrode (hereinafter referred to as "the Q electrode") and a reflector (hereinafter referred to as "the I electrode") arranged with a geometric phase difference $\phi$ and each impressed with a voltage having an electrical phase difference $\theta$ and a voltage ratio of 1: $\xi$, or group-type unidirectional transducers having a plurality of groups of the electrodes,

wherein the conductance Gq of the Q electrode, the conductance Gi of the I electrode, the voltage ratio $\xi$, the geometric phase difference $\phi$ and the electrical phase difference $\theta$ have a relation given as

$$\xi = \sqrt{Gq/Gi}$$

and

$$\theta - \phi = (2n-1)\pi \text{ or } \theta + \phi = (2n-1)\pi \qquad (1)$$

where n is an integer and $\phi \neq n\pi$.

In another embodiment of the invention, there is provided a surface acoustic wave module comprising a plurality of interdigital transducers on a piezoelectric substrate for transmitting and receiving the surface acoustic wave, at least one of the transducers including unidirectional transducers having a combination of m pairs of Q electrodes and k pairs of I electrodes arranged with a geometric phase difference $\phi$, each impressed with a voltage having an electrical phase difference $\theta$ and voltage ratio of 1:$\xi$, or group-type unidirectional transducers having a plurality of groups of electrodes, each type of transducer having a non-apodizing interdigital transducer;

wherein the number m of pairs of Q electrode, the number k of pairs of I electrodes, the voltage ratio $\xi$, the geometric phase difference $\phi$ and the electrical phase difference $\theta$ have a relation given as

$$\xi = m/k$$

and

$$\theta - \phi = (2n-1)\pi \text{ or } \theta + \phi = (2n-1)\pi \tag{2}$$

where n is an integer and $\phi \neq n\pi$ (n: Integer)

In still another embodiment of the invention, there is provided a surface acoustic wave module comprising a plurality of interdigital transucers on a piezoelectric substrate for transmitting and receiving a surface acoustic wave, at least one of the transducers including a plurality of unidirectional transducers having a transmitting electrode (hereinafter referred to as "the Q electrode") and a reflector (hereinafter referred to as "the I electrode") arranged with a geometric phase difference $\phi$, each impressed with a voltage having an electrical phase difference $\theta$ and a voltage ratio of 1:$\xi$, or group-type unidirectional transducers having a plurality of the groups in the number N,

wherein each of the Q and I electrodes is connected in parallel with an electric phase shifter, the two electrodes being connected in series with each other,

the geometric phase difference $\phi$ being not an integral multiple of $\pi$ radians,

the susceptance of the electric phase shifter connected to the Q electrode being given as

$$\sqrt{GqGi} \ (1+1/N)\sin\phi - Bq \tag{3}$$

the susceptance of the electric phase shifter connected to the I electrode being given as

$$- \sqrt{GqGi} \ (1-1/N)\sin\phi - Bi \tag{4}$$

where Gq is the conductance of the Q electrode, Gi the conductance of the I electrode, Bq the susceptance of the Q electrode and Bi the susceptance of the I electrode.

In yet another embodiment of the invention, there is provided a surface acoustic wave module having an I electrode connected in parallel with an electric phase shifter, with the Q and I electrodes being connected in series with each other, wherein the conductance Gq of the Q electrode, the conductance Gi of the I electrode, the susceptance Bq of the Q electrode, the geometric phase difference $\phi$ and the number N of groups have a relation given as

$$\sqrt{GqGi} \ (1+1/N) \sin\phi - Bq = 0 \tag{5}$$

and the geometric phase difference $\phi$ is not an integral multiple of $\pi$ radians, the susceptance of the electrical element connected to the I electrode being given as

$$- \sqrt{GqGi} \ (1-1/N)\sin\phi - Bi \tag{6}$$

In still another embodiment of the invention, there is provided a surface acoustic wave module configured of an electric phase shifter connected in parallel to a Q electrode which in turn is connected in series with an I electrode, wherein the conductance Gq of the Q electrode, the conductance Gi of the I electrode, the susceptance Bi of the I electrode, the geometric phase difference $\phi$ and the number N of groups have a relation given as

$$- \sqrt{GqGi} \ (1-1/N)\sin\phi - Bi = 0 \tag{7}$$

and the geometric phase difference $\phi$ is not an integral multiple of $\pi$ radians, the susceptance of the electric phase shifter connected to the Q electrode being given as

$$\sqrt{GqGi} \ (1+1/N)\sin\phi - Bq \tag{8}$$

In yet another preferred embodiment of the invention, there is provided a surface acoustic wave module comprising interdigital transducers on a piezoelectric substrate for transmitting and receiving a surface acoustic wave, at least one of the transducers providing a unidirectional transducer including a combination of a Q electrode and an I electrode arranged with a geometric phase difference $\phi$, or a group-type unidirectional transducer including a number N of groups,

wherein the Q electrode and the I electrode are connected in series each with an electric phase shifter and connected in parallel to each other,
the geometric phase differece $\phi$ is not an integral multiple of $\pi$ radians, and
the susceptance of the electric phase shifter connected to the Q electrode is given as

$$\frac{BiBqN^2 + \left(N^2 - 1\right)GiGq\sin^2\phi}{-N^2Bi - \sqrt{GqGi} \ N\,(N+1)\,\sin\phi} \tag{9}$$

the susceptance of the electric element connected to the I electrode being given as

$$\frac{BiBqN^2 + \left(N^2 - 1\right)GqGi\sin^2\phi}{-N^2Bq - \sqrt{GqGi} \ N\,(N-1)\,\sin\phi} \tag{10}$$

where Gq is the conductance of the Q electrode, Gi the conductance of the I electrode, Bq the susceptance of the Q electrode, and Bi the susceptance of the I electrode.

In another preferred embodiment of the invention, there is provided a surface acoustic wave module configured of an electric phase shifter connected in series with a Q electrode which in turn is connected in parallel to an I electrode, wherein the conductance Gq of the Q electrode, the conductance Gi of the I electrode, the susceptance Bq of the Q electrode, the geometric phase difference $\phi$ and the number N of groups have a relation given as

$$-N^2Bq - \sqrt{GqGi} \ N(N-1)\sin\phi = 0 \tag{11}$$

and the geometric phase difference $\phi$ is not an integral multiple of $\pi$ radians, the susceptance of the electric phase shifter connected to the Q electrode being given as

$$\frac{BiBqN^2 + \left(N^2 - 1\right)GiGq\sin^2\phi}{-N^2Bi + \sqrt{GqGi} \ N\,(N+1)\,\sin\phi} \tag{12}$$

Furthermore, in yet another preferred embodiment of the invention, there is provided a surface acoustic wave module configured of an electric phase shifter connected in series with an I electrode which in turn is connected in parallel to a Q electrode, wherein the conductance Gq of the Q electrode, the conductance Gi of the I electrode, the susceptance Bi of the I electrode, the geometric phase difference $\phi$ and the number N of groups have a relation given as

5

$$-N^2 Bi \pm \sqrt{GqGi} \, N(N+1)\sin\phi = 0 \qquad\qquad (13)$$

and the geometric phase difference is not an integral multiple of $\pi$ radians, the susceptance of the electric phase shifter connected to the I electrode being given as

$$\frac{BiBqN^2 + \left(N^2 - 1\right)GqGi\sin^2\phi}{-N^2 Bq - \sqrt{GqGi} \, N(N-1)\sin\phi} \qquad\qquad (14)$$

BRIEF DESCRIPTION OF THE DRAWINGS

Fig. 1 is a block diagram showing a mobile station for digital communication system;

Fig. 2 is a block diagram showing a mobile station for analog communication system;

Fig. 3 is a model diagram showing a surface acoustic wave module having a unidirectional transducer;

Fig. 4 is a partly-enlarged plan view of a unidirectional transducer;

Fig. 5 is an equivalent circuit diagram of a four-port network of a unidirectional transducer;

Fig. 6 is an equivalent circuit diagram of a piezoelectric material;

Figs. 7A and 7B are diagrams illustrating equivalent circuits of a unit section for electrode of a surface acoustic wave module according to the present invention;

Figs. 8A and 8B are diagrams illustrating equivalent circuits of a pair of unit sections for electrode of a surface acoustic wave module according to the present invention;

Figs. 9A and 9B are diagrams illustrating equivalent circuits of a group of unit sections for electrode of a surface acoustic wave module according to the present invention;

Figs. 10A and 10B are diagrams for explaining the function of a surface acoustic wave module according to the present invention;

Figs. 11A and 11B are diagrams for explaining admittance matrix of one group of an interdigital transducer of a surface acoustic wave module according to the present invention;

Figs. 12A and 12B are diagrams for explaining a four-port network of group-type unidirectional transducer of a surface acoustic wave module according to the present invention;

Fig. 13 is a diagram for explaining the function of a surface acoustic wave module according to the present invention;

Fig. 14 is a partly-enlarged view of another surface acoustic wave module which may be used with an embodiment of the present invention;

Fig. 15 is a characteristic diagram of a surface acoustic wave module used with an embodiment of the present invention;

Fig. 16 is a model plan view showing an embodiment of a surface acoustic wave module according to the present invention;

Fig. 17 is a model plan view showing an electrode configuration of a reference for comparison;

Fig. 18 is an equivalent circuit diagram for explaining the function of a surface acoustic wave module according to the present invention;

Fig. 19 is a model plan view showing an embodiment of a surface acoustic wave module according to the present invention;

Fig. 20 is a characteristic diagram of a surface acoustic wave module used with an embodiment of the present invention;

Fig. 21 is an equivalent circuit diagram for explaining the function of a surface acoustic wave module according to the present invention;

Fig. 22 is a characteristic diagram of a surface acoustic wave module used with an embodiment of the present invention;

Fig. 23 is a characteristic diagram of a surface acoustic wave module used with an embodiment of the present invention;

Fig. 24 is a characteristic diagram of a surface acoustic wave module used with an embodiment of the present invention;

Fig. 25 is a partly-enlarged view of another surface acoustic wave module which may be used with an embodiment of the present invention;

Fig. 26 is a circuit diagram of a voltage-controlled oscillator used with an embodiment of the present invention;

Fig. 27 is a model diagram of a surface acoustic wave module used with a voltage-controlled oscillator in an embodiment of the present invention;

Fig. 28 is a sectional view of a surface-mount type package used with an embodiment of the present invention;

Fig. 29 is a model plan view showing an embodiment of a surface acoustic wave module according to the present invention;

Fig. 30 is a characteristic diagram of a surface acoustic wave module used with an embodiment of the present invention; and

Fig. 31 is an equivalent circuit diagram for explaining the function of a surface acoustic wave module according to the present invention.

DESCRIPTION OF THE PREFERRED EMBODIMENTS

Firstly, prior to the explanation of embodiments of the present invention, the function of a surface acoustic wave module according to the present invention will be explained with reference to the accompanying drawings.

A surface acoustic wave filter having a unidirectional transducer in a radio frequency circuit and an intermediate frequency circuit is adapted to filter and transmit a signal in the frequency band (approximately 20 kHz in bandwidth for GSM) of the above-mentioned digital system, with a high phase linearility and a small group delay deviation and loss.

Further, the surface acoustic wave element of a voltage-controlled oscillator in the frequency synthesizer reduces the fluctuations of oscillation frequency and improves the oscillation resistance.

Also, the surface-mount type package for housing the surface acoustic wave element increases the wiring density of the substrate while at the same reducing the wiring inductance, stray capacitance, etc.

Firstly, the function of a surface acoustic wave module according to the present invention will be explained with reference to the accompanying drawings prior to the explanation of embodiments thereof.

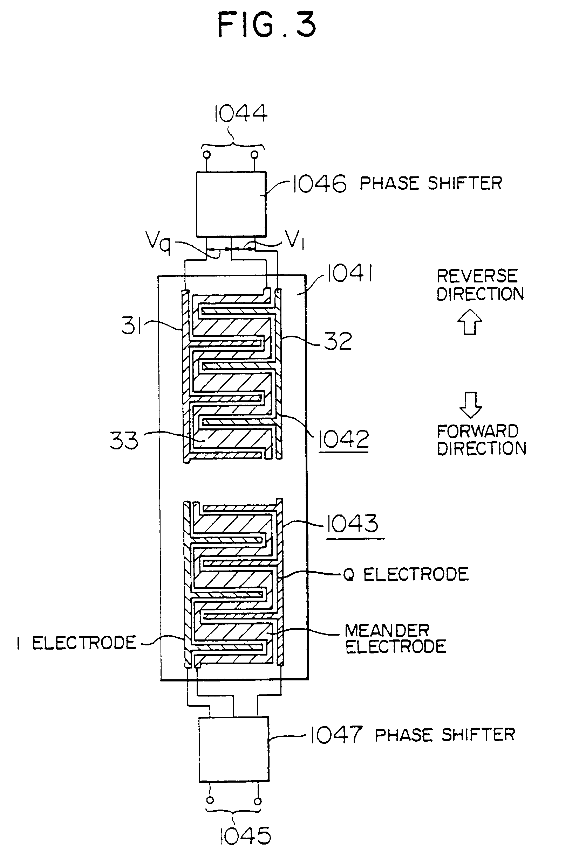

An example of the surface acoustic wave module is shown in the model diagram of Fig. 3. In Fig. 3, 1041 designates a substrate having a piezoelectric property, 1042 a sending transducer, and 1043 a receiving transducer. Also, 1044 designates an electrical signal input terminal, and 1045 an electrical signal output terminal. 1046, 1047 designate an electrical phase shifter.

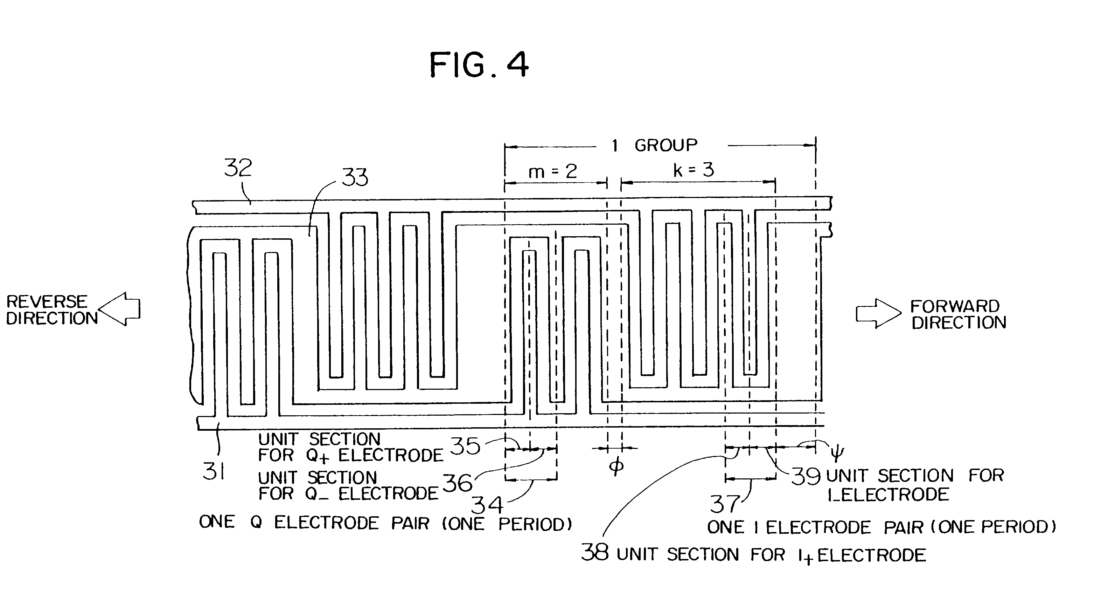

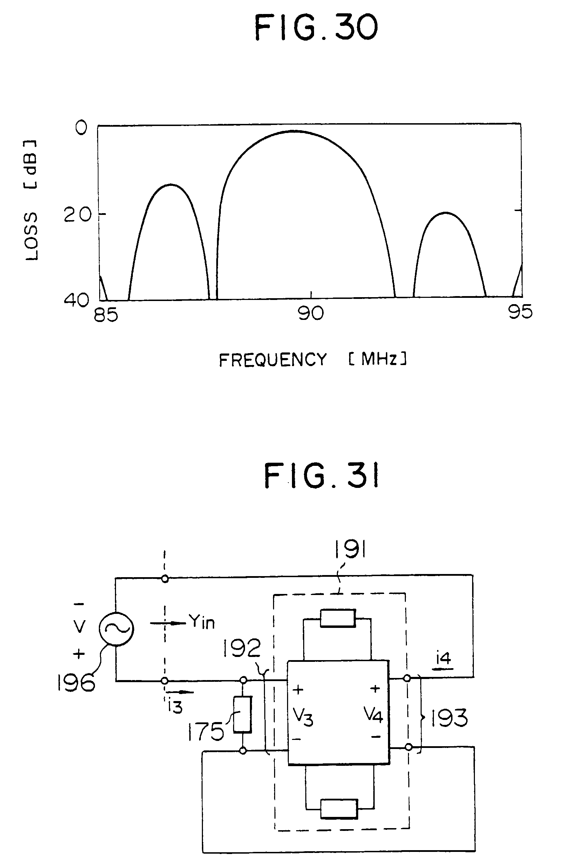

Fig. 4 shows a partially-enlarged view of a group-type unidirectional transducer constructed on the substrate 1041 and used as the sending transducer 1042 and the receiving transducer 1043 (or one of them). In Fig. 4, the transducer is shown as an interdigital one of solid type with the width of the electrode as large as one fourth the wavelength of the surface acoustic wave. In Fig. 4, 31 designates a Q electrode, 32 an I electrode and 33 a meander electrode.

A group-type unidirectional transducer is configured of a number N of repetitive groups each including an I electrode 32 having k pairs per period and a Q electrode 31 having m pairs per period. In the case where the number N of groups is 1, it is simply called a unidirectional transducer. Nevertheless, a group-type unidirectional transducer is assumed to include such a case herein.

Indication of an equivalent circuit of an interdigital electrode will be explained below.

Now, the central frequency $f_0$ of an excited surface acoustic wave has a relation shown by the following equation (15) with the propagation speed v of the surface acoustic wave of the piezoelectric wave and the wavelength $\lambda$ of the surface acoustic wave

$$f_0 = v/\lambda \qquad (15)$$

The geometric phase difference $\phi$ and $\Psi$ between electrodes in Fig. 4 represent the coverage of the surface acoustic wave at the central frequency $f_0$ expressed by the angle (radians).

By the way, for convenience' sake, the forward and reverse directions are determined with reference to the direction shown in Fig. 4 in terms of progress of the surface acoustic wave.

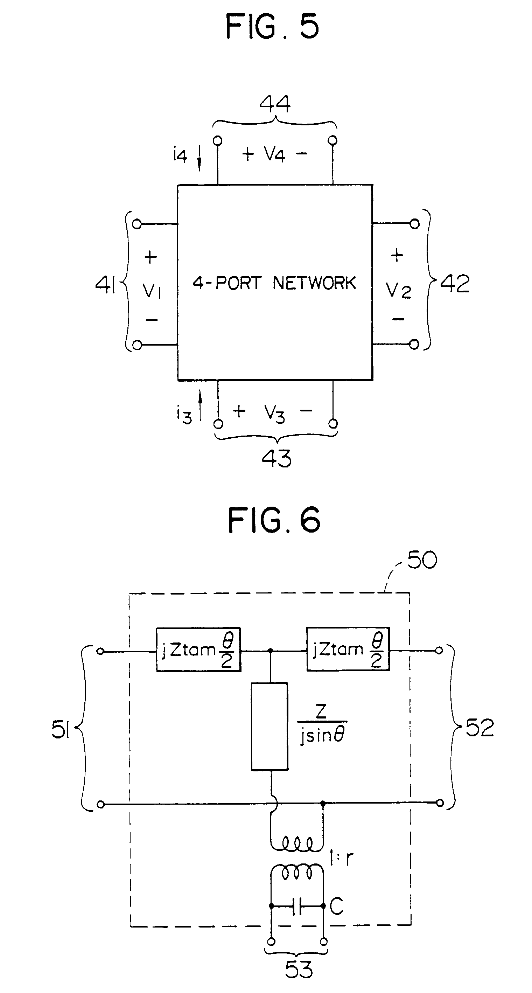

The interdigital electrode having a number N of groups each including k pairs of I electrodes and m pairs of Q electrodes is considered to be a four-port circuit network shown in Fig. 5, and the admittance in the neighbourhood of the central frequency thereof is introduced in accordance with the procedure of (a) to (e) described below. A first port 41 and a second port 42 represent a reverse (Q-electrode side) acoustic terminal and a forward (I-electrode side) acoustic terminal respectively, while a third port 43 and a fourth port 44 represent the electric terminals of the Q and I electrodes respectively.

(a) Equivalent circuit for a pair of electrodes

Mason's equivalent circuit model (cross field model) used for bulky oscillation in piezoelectric material is shown in Fig. 6. A first port 51 and a second port 52 are acoustic terminals corresponding to the oscillation surface, and a third port 53 an electrical terminal. Also, Z designates a characteristic impedance of the surface acoustic wave, and $\theta$ the path length 1 of the acoustic wave in angle (radians) as expressed below

$$\theta = 2\pi\ 1/\lambda = 2\pi\ f_0 1/v \qquad\qquad (16)$$

where r and c are the transformation ratio and the capacitance respectively.

This Mason's model is applicable also to the equivalent circuit of the interdigital transducer. For this purpose, the characteristic impedances of the electrode portion 61 and the non-electrode portion 62 of the interdigital transducer may assume a value Z0 and Zm corresponding to $\theta$, r and c respectively.

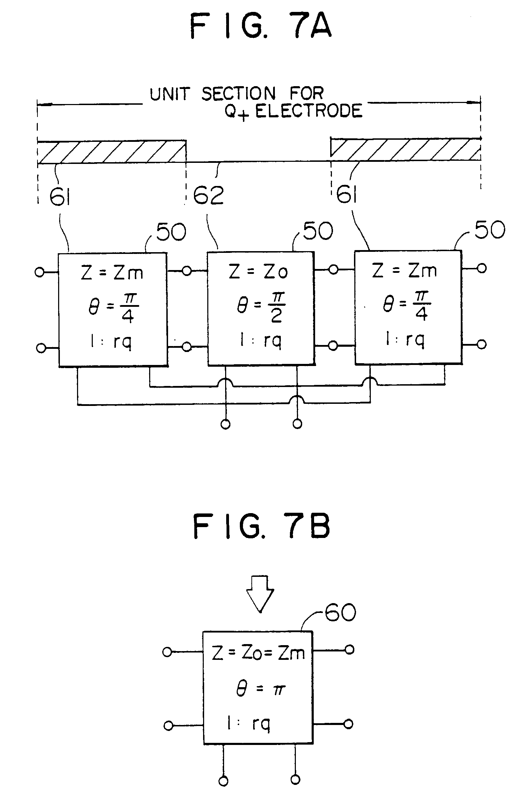

The basic unit (including the $\lambda/8$ electrode portion 61, the $\lambda/4$ non-electrode portion 62 and the $\lambda/8$ electrode portion 61) 35 of the $Q_+$ electrode shown in Fig. 4 may be expressed as Fig. 7A using Mason's equivalent circuit 50 of Fig. 6. In Fig. 7A, one black box corresponds to the equivalent circuit 50 of Fig. 6. In this diagram, rq represents the transformation ratio of the $Q_+$ electrode.

Assuming that the characteristic impedance Z0 of the electrode portion 61 is approximated as identical to the characteristic impedance Zm of the non-electrode portion 62, the equivalent circuit of Fig. 7A can be synthesized easily, thereby forming an equivalent circuit 60 having the transformation ratio of rq as shown in Fig. 7B. Further, the basic unit 36 of the $Q_-$ electrode having the transformation ratio of -rq can be expressed in similar fashion.

By the way, for simplifying the computation procedure, all the electrode capacitance c is removed temporarily before considering an equivalent circuit, and is connected in the end.

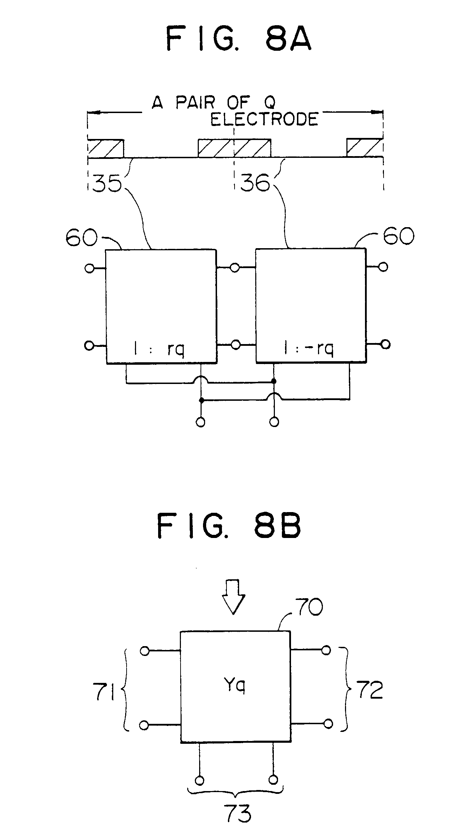

Next, the basic unit 35 of the $Q_+$ electrode and the basic unit 36 of the $Q_-$ electrode shown in Fig. 8A may be combined as an equivalent circuit 70 shown in Fig. 8B. An equivalent circuit 34 corresponding to one pair of Q electrodes is determined.

In Fig. 8B, 71, 72 designate a first port and a second port providing an acoustic terminal, respectively, and 73 designates a third port providing an electrical terminal. When the path lengths $\theta_+$, $\theta_-$ of the $Q_+$ and $Q_-$ electrodes are in the neighbourhood of $\pi$ ($\theta_+$, $\theta_- = \pi + \delta$), the admittance matrix Yq of a pair of Q electrodes is given by the equation below

$$Yq = \begin{bmatrix} \dfrac{j}{2\delta} & \dfrac{-j}{2\delta} & \dfrac{-j2rq}{\delta} \\[2ex] \dfrac{-j}{2\delta} & \dfrac{j}{2\delta} & \dfrac{j2rq}{\delta} \\[2ex] \dfrac{-j2rq}{\delta} & \dfrac{j2rq}{\delta} & \dfrac{j8rq^2}{\delta} \end{bmatrix} \quad \cdots\cdots (17)$$

(b) Equivalent circuit for m pairs

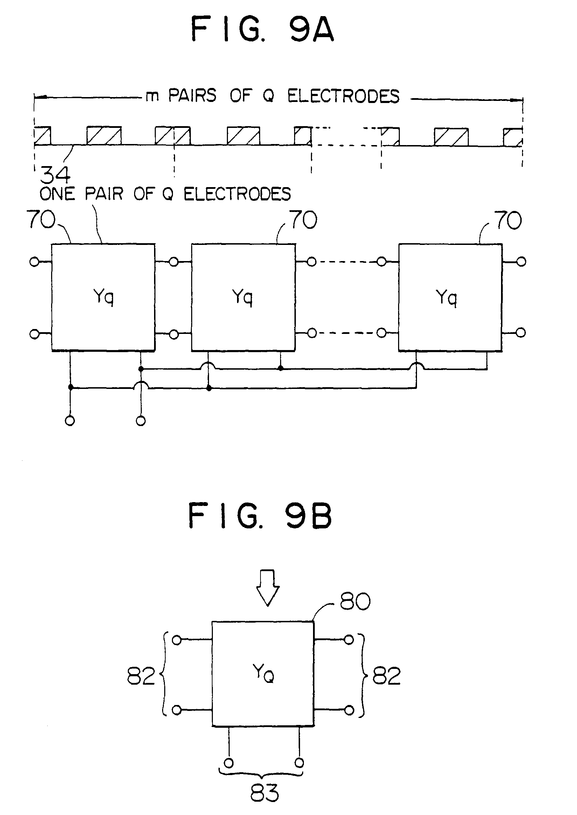

The Q electrodes in one group shown in Fig. 9A, i.e., the equivalent circuit 80 for m pairs is expressed by a combined equivalent circuit shown in Fig. 9B, and the admittance matrix $Y_Q$ thereof is given as

$$Y_Q = \begin{bmatrix} \dfrac{j}{2m\delta} & \dfrac{-j}{2m\delta} & \dfrac{-j2rq}{\delta} \\[2ex] \dfrac{-j}{2m\delta} & \dfrac{j}{2m\delta} & \dfrac{j2rq}{\delta} \\[2ex] \dfrac{-j2rq}{\delta} & \dfrac{j2rq}{\delta} & \dfrac{j8mrq^2}{\delta} \end{bmatrix} \quad \cdots\cdots (18)$$

In Fig. 9B, 81, 82 designate first and second ports providing an acoustic terminal, and 83 a third port providing an electrical terminal.

In similar fashion, the I electrode in one group, i.e., the admittance matrix $Y_I$ for k pairs of equivalent circuit is given by equation

$$Y_I = \begin{bmatrix} \dfrac{j}{2k\delta'} & \dfrac{-j}{2k\delta'} & \dfrac{-j2r_i}{\delta'} \\[2ex] \dfrac{-j}{2k\delta'} & \dfrac{j}{2k\delta'} & \dfrac{j2r_i}{\delta'} \\[2ex] \dfrac{-j2r_i}{\delta'} & \dfrac{j2r_i}{\delta'} & \dfrac{j8kr_i^2}{\delta'} \end{bmatrix} \qquad \cdots\cdots \quad (19)$$

where $r_i$ is the transformation ratio of the basic unit 38 of the $I_+$ electrode, $\delta'$ the minor difference from $\pi$ of the transit lengths of the unit section 38 of the $I_+$ electrode and the unit section 39 of the I electrode.

(c) Geometric phase difference between Q and I electrodes and connection of $\psi$ to the propagation path

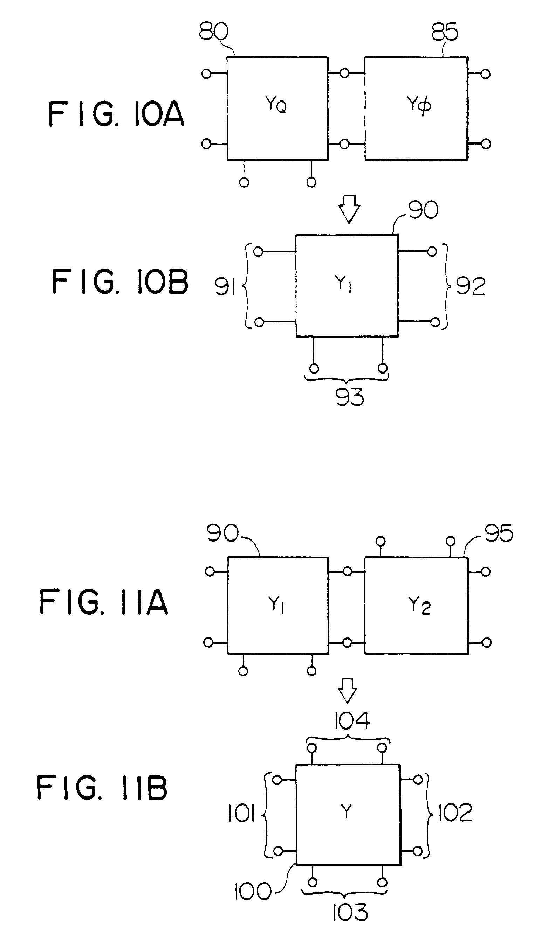

The admittance matrix $Y_I$ (Fig. 10B) of a combined equivalent circuit is determined for a case in which the m pairs of Q electrodes (with the admittance matrix thereof as $Y_Q$) 80 shown in Fig. 10A are connected with a surface acoustic wave propagation path 85 of the geometric phase difference $\phi$. In this case, the geometric phase difference portion to be coupled has no relation with the excitation of a surface acoustic wave, and the admittance matrix $Y\phi$ for this portion is given by

$$Y_\phi = \frac{1}{j\sin\phi} \begin{bmatrix} \cos\phi & -1 \\ -1 & \cos\phi \end{bmatrix} \qquad \cdots\cdots \quad (20)$$

In the case where a propagation path of the geometric phase difference $\phi$ is connected to the Q electrode, the admittance matrix Y1 of the three-port network 90 is given as

$$Y1 = \begin{bmatrix} \dfrac{-j\cos\phi}{\sin\phi-2\delta m\cos\phi} & \dfrac{j}{\sin\phi-2\delta m\cos\phi} & \dfrac{j4r_q m\cos\phi}{\sin\phi-2m\delta\cos\phi} \\[2ex] \dfrac{j}{\sin\phi-2\delta m\cos\phi} & \dfrac{-j(\cos\phi+2m\delta\sin\phi)}{\sin\phi-2m\delta\cos\phi} & \dfrac{-j4mr_q}{\sin\phi-2m\delta\cos\phi} \\[2ex] \dfrac{j4r_q m\cos\phi}{\sin\phi-2m\delta\cos\phi} & \dfrac{-j4mr_q}{\sin\phi-2m\delta\cos\phi} & \dfrac{-j16m^2 r_q\cos\phi}{\sin\phi-2\delta m\cos\phi} \end{bmatrix}$$

$$\cdots\cdots \quad (21)$$

In Fig. 10B, 91, 92 designate first and second ports respectively providing an acoustic terminal, and 93 a third port providing an electrical terminal.

In similar fashion, in the case where k pairs of I electrodes are connected with a propagation path of the surface acoustic wave of the mechanical phase difference $\phi$, the admittance matrix Y2 of three terminal-pair circuit network is given as

$$
Y2 = \begin{bmatrix} \dfrac{-j\cos\psi}{\sin\psi - 2\delta'k\cos\psi} & \dfrac{j}{\sin\psi - 2\delta'k\cos\psi} & \dfrac{j4r_i k\cos\psi}{\sin\upsilon - 2k\delta'\cos\psi} \\[4mm] \dfrac{j}{\sin\psi - 2\delta'k\cos\upsilon} & \dfrac{-j(\cos\psi + 2k\delta'\sin\upsilon)}{\sin\upsilon - 2k\delta'\cos\psi} & \dfrac{-j4kr_i}{\sin\upsilon - 2k\delta'\cos\psi} \\[4mm] \dfrac{j4r_i k\cos\psi}{\sin\psi - 2k\delta'\cos\upsilon} & \dfrac{-j4kr}{\sin\upsilon - 2k\delta'\cos\psi} & \dfrac{-j16k^2 r_i \cos^2\psi}{\sin\upsilon - 2\delta'k\cos\psi} \end{bmatrix}
$$

$$.... \quad (22)$$

This three-port network 95 is shown in Fig. 11A.

(d) Admittance matrix of one group

The above-mentioned three-port networks 95(Y1) and 96(Y2) are connected in the manner shown in Fig. 11A. In Fig. 11B, 101, 102 designate first and second ports respectively providing acoustic terminals for forward and reverse directions. 103, 104 designate third and fourth ports providing electrical terminals of the Q and I electrodes respectively. The admittance matrix Y of the four-port network 100 of one group of the interdigital transducer is give as

$$
Y = \begin{bmatrix} \dfrac{j}{\varepsilon} & \dfrac{-j}{\varepsilon} & \dfrac{-j4mr_q}{\varepsilon} & \dfrac{-j4kr_i b}{\varepsilon} \\[4mm] \dfrac{-j}{\varepsilon} & \dfrac{j}{\varepsilon} & \dfrac{j4mr_q}{\varepsilon} & \dfrac{j4kr_i a}{\varepsilon} \\[4mm] \dfrac{-j4mr_q}{\varepsilon} & \dfrac{j4mr_q}{\varepsilon} & \dfrac{j16m^2 r_q^{\,2}}{\varepsilon} & \dfrac{j16mr_q kr_i b}{\varepsilon} \\[4mm] \dfrac{-j4kr_i b}{\varepsilon} & \dfrac{j4mr_q}{\varepsilon} & \dfrac{j16mr_q kr_i b}{\varepsilon} & \dfrac{j16k^2 r_i^{\,2} ab}{\varepsilon} \end{bmatrix}
$$

$$.... \quad (23)$$

where $\phi + \psi = 2\pi - \varepsilon$.

(e) Expression of four-port network of group-type unidirectional transducer

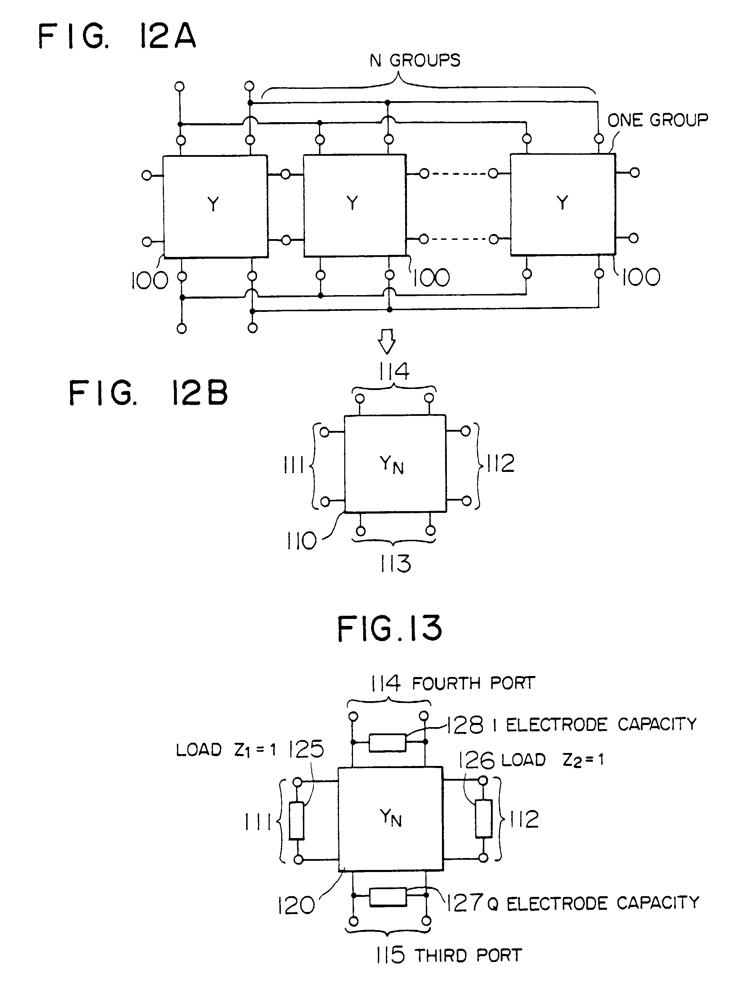

The four-port network is connected in a number N of groups as shown in Fig. 12A. In Fig. 12B, 111, 112 designate first and second ports providing acoustic terminals for reverse and forward directions respectively, and 113, 114 third and fourth ports providing electrical terminals of the Q and I electrodes respectively. Each element yij of the admittance matrix $Y_N$ of this combined four-port network 110 is expressed by the equation shown below. It should be noted here that $Y_N$ is a symmetric matrix holding the relation yij = yji (i, j = 1, 2, 3, 4).

$$Y_{11} = Y_{22} = \frac{j}{N\epsilon} \quad , \quad Y_{12} = \frac{i}{N\epsilon}$$

$$Y_{13} = \frac{-j4mr_q}{\epsilon} \quad , \quad Y_{14} = \frac{-j4kr_i b}{\epsilon} \pm j2(N-1)kr_i\sqrt{1-b^2}$$

$$Y_{23} = \frac{j4mr_q}{\epsilon} \quad , \quad Y_{24} = \frac{j4kr_i a}{\epsilon} \pm j2(N-1)kr_i\sqrt{1-b^2}$$

$$Y_{33} = \frac{j16Nm^2r_q^2}{\epsilon} \quad , \quad Y_{34} = \frac{j16Nmr_q kr_i b}{\epsilon}$$

$$Y_{44} = \frac{j16Nk^2r_i^2 ab}{\epsilon}$$

$$\ldots \; (24)$$

Provided, however that the double sign of the 14 and 24 elements is assumed to be "+" when $0 \leq \phi \leq \pi \leq \psi \leq 2\pi$, and "-" when $0 \leq \psi \leq \pi \leq \phi \leq 2\pi$. Also, the electrode capacitance is not shown for 33 and 44 elements.

The foregoing is the description of an admittance matrix of a four-port network in the neightbourhood of $\epsilon$ of the central frequency $f_0$ of an interdigital transducer having N groups of a combination k pairs of l electrodes and m pairs of Q electrodes.

Next, as shown in Fig. 13, the first port 111 and the second port 112 providing acoustic terminals of the above-mentioned N-group unidirectional transducer is terminated at a load 125 for reverse direction and at a load 126 for forward direction having the characteristic impedance of $Z_1 = Z_2$. In the process, the admittance matrix of the two-port network of a unidirectional transducer can be obtained in the manner mentioned below.

$$i_1 = -v_1 \tag{25}$$

$$i_2 = -v_2 \tag{26}$$

Thus, the circuit equation is given as

$$\begin{bmatrix} 0 \\ 0 \\ i_3 \\ i_4 \end{bmatrix} = \begin{bmatrix} y_{11}+1 & y_{12} & y_{13} & y_{14} \\ y_{12} & y_{22}+1 & y_{23} & y_{24} \\ y_{13} & y_{23} & y_{33} & y_{34} \\ y_{14} & y_{24} & y_{34} & y_{44} \end{bmatrix} \begin{bmatrix} v_1 \\ v_2 \\ v_3 \\ v_4 \end{bmatrix}$$

$$\dots\dots (27)$$

From the bottom two lines of Equation (27),

$$\begin{bmatrix} i_3 \\ i_4 \end{bmatrix} = \begin{bmatrix} y_{13} & y_{23} \\ y_{14} & y_{24} \end{bmatrix} \begin{bmatrix} v_1 \\ v_2 \end{bmatrix} + \begin{bmatrix} y_{33} & y_{34} \\ y_{34} & y_{44} \end{bmatrix} \begin{bmatrix} v_3 \\ v_4 \end{bmatrix}$$

$$\dots\dots (28)$$

Also, from the top two lines of Equation (27),

$$\begin{bmatrix} v_1 \\ v_2 \end{bmatrix} = -\begin{bmatrix} y_{11}+1 & y_{12} \\ y_{12} & y_{22}+1 \end{bmatrix}^{-1} \begin{bmatrix} y_{13} & y_{14} \\ y_{23} & y_{24} \end{bmatrix} \begin{bmatrix} v_3 \\ v_4 \end{bmatrix}$$

$$= \frac{1}{\Delta} \begin{bmatrix} y_{12}y_{23}-(y_{22}+1)y_{13} & y_{12}y_{24}-(y_{24}+1)y_{14} \\ y_{12}y_{13}-(y_{11}+1)y_{23} & y_{12}y_{14}-(y_{11}+1)y_{24} \end{bmatrix} \begin{bmatrix} v_3 \\ v_4 \end{bmatrix}$$

$$\dots\dots (29)$$

provided, however, that

$$\Delta = (y_{11}+1)(y_{22}+1) - y_{12}^{2} \qquad\qquad (30)$$

Substituting Equation (29) into Equation (28),

$$\begin{bmatrix} i_3 \\ i_4 \end{bmatrix} = \frac{1}{\Delta} \begin{bmatrix} Y_{13} & Y_{22} \\ Y_{14} & Y_{24} \end{bmatrix} \begin{bmatrix} Y_{12}Y_{23} - (Y_{22}+1)Y_{13} \\ Y_{12}Y_{13} - (Y_{11}+1)Y_{23} \end{bmatrix}$$

$$\begin{bmatrix} Y_{12}Y_{24} - (Y_{22}+1)Y_{14} \\ Y_{12}Y_{14} - (Y_{11}+1)Y_{24} \end{bmatrix} \begin{bmatrix} v_3 \\ v_4 \end{bmatrix} + \begin{bmatrix} Y_{33} & Y_{34} \\ Y_{34} & Y_{44} \end{bmatrix} \begin{bmatrix} v_3 \\ v_4 \end{bmatrix}$$

$$\dots (31)$$

When each element of yij of Equation (24) is substituted into this equation to reduce $\varepsilon$ to zero and the capacitances jBq, jBi of the Q and I electrodes indicated by 127, 128 in Fig. 13 are added, the admittance expression of a two-port network with the central frequency of $f_0$ is obtained in the manner shown below

$$\begin{bmatrix} i_3 \\ i_4 \end{bmatrix} = \begin{bmatrix} 8m^2 r_q^2 N^2 + jBq & 8Nmkr_q r_i (Ncos\phi - jsin\phi) \\ 8Nmkr_q r_i (Ncos\phi - jsin\phi) & 8k^2 r_i^2 N^2 + jBi \end{bmatrix}$$

$$\begin{bmatrix} v_3 \\ v_4 \end{bmatrix}$$

$$\dots (32)$$

For simplifying the explanation, the following definition is made.

$$Gq: = 8m^2 rq^2 N^2, \qquad Gi: = 8k^2 ri^2 N^2 \tag{33}$$

Then, Equation (32) is described simply as follows

$$\begin{bmatrix} i_3 \\ i_4 \end{bmatrix} = \begin{bmatrix} Gq + jBq & \sqrt{GqGi}(cos\phi - j(sin\phi)/N) \\ \sqrt{GqGi}(cos\phi - j(sin\phi)/N) & Gi + jBi \end{bmatrix} \begin{bmatrix} v_3 \\ v_4 \end{bmatrix}$$

$$\dots (34)$$

Conditions for surface acoustic wave module for assuring complete unidirectivity will be explained hereinafter.

As to the configuration shown in Fig. 13, the power of radiation in each direction (forward and reverse directions) can be expressed by power consumption at $Z_1$ and $Z_2$.

In order to determine the power consumption for the central frequency $F_0$ at $Z_1$ and $Z_2$, each element expressed by Equation(24) is substituted into Equation (29) to reduce $\varepsilon$ to zero. Thus,

$$\begin{bmatrix} v_1 \\ v_2 \end{bmatrix} = \begin{bmatrix} 2Nmr_q & 2Nkr_i(\cos\phi+j\sin\phi) \\ -2Nmr_q & -2Nkr_i(\cos\phi+j\sin\phi) \end{bmatrix} \begin{bmatrix} v_3 \\ v_4 \end{bmatrix} \quad \dots\ (35)$$

Now, $v_3$ and $v_4$ are assumed to have a relation shown below

$$v_4 = \xi\exp(j\theta)_v 3 \tag{36}$$

$$\xi = |v_4|/|v_3| \tag{37}$$

$$\tan\theta = \mathrm{Imag}(v_4/v_3)/\mathrm{Real}(v_4/v_3) \tag{38}$$

Specifically, $v_4$ is assumed to have an amplitude $\xi$ times larger than the voltage of $v_3$ and the phase advance (electrical phase difference) to be $\theta$.

Then, Equation (35) is rewritten as

$$\begin{bmatrix} v_1 \\ v_2 \end{bmatrix} = \begin{bmatrix} 2N[mr_q+\xi kr_i\exp\{j(\theta-\phi)\}] \\ -2N[mr_q+\xi kr_i\exp\{j(\theta+\phi)\}] \end{bmatrix} v_3 \quad \dots\ (39)$$

Determining the power ratio $\alpha$ between $Z_1$ and $Z_2$,

$$\alpha = \frac{|v_1|^2}{|v_2|^2} = \frac{|mr_q+\xi kr_1\exp\{j(\theta-\phi)\}|^2}{|mr_q+\xi kr_1\exp\{j(\theta-\phi)\}|^2}$$

$$= \frac{R^2+2R\cos(\theta-\phi)+1}{R^2+2R\cos(\theta+\phi)+1} \tag{40},$$

on condition that

$$R := \xi\frac{kr_i}{mr_q} \tag{41}$$

Now, assume that

$$\text{(1)} \quad R=1, \text{ i.e., } \xi = \frac{mr_q}{kr_i}, \text{ i.e., } \xi = \frac{\sqrt{Gq}}{\sqrt{Gi}} \quad \text{and}$$

$$\text{(2)} \quad \vartheta - \phi = (2n-1)\pi \quad (n: \text{ Integer}), \text{ and}$$

$$\text{(3)} \quad \theta \neq n\pi \quad (n: \text{ Integer})$$

$$\dots\dots \quad (42)$$

It is easly understood from Equation (40) that $\alpha = 0$ (The specified conditions indicate that the denominator of Equation (40) will not become zero). Specifically, when the conditions (1) to (3) or Equation (42) are established, the surface acoustic wave from the interdigital transducer is radiated only in one direction. If these conditions are met, power is propagated only in one (forward) direction, thereby securing a low-loss surface acoustic wave module.

Also, as will be easily understood, if the conditions of (2) of Equation (42) are replaced by

$$\text{(2)}' \quad \theta - \phi = (2n - 1)\pi \qquad (n: \text{ Integer}),$$

then, complete unidirectivity in backward direction is obtained.

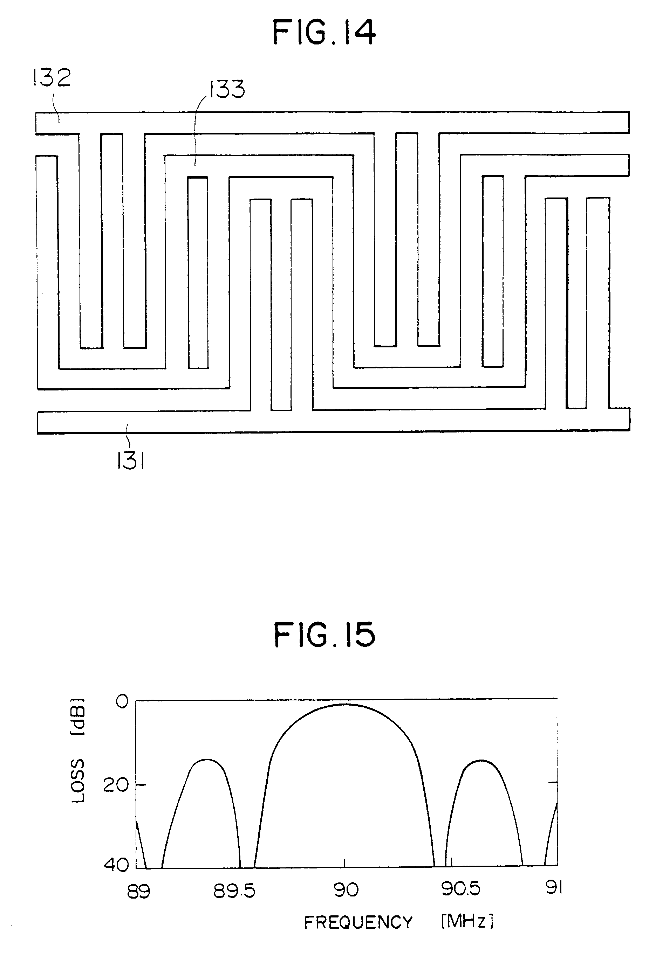

Although the foregoing description concerns a solid-type interdigital transducer having an electrode width as large as one fourth the wavelength of the central frequency as shown in Fig. 4, exactly the same thing can be said of a split-connected type interdigital transducer with an electrode width as large as one eighth of the wavelength of the central frequency as shown in Fig. 14. In Fig. 4, 131 designates a Q electrode, 132 an I electrode and 132 a meander electrode.

Preferred embodiments of a station for digital communication system and a surface acoustic wave module according to the present invention will now be explained with reference to the accompanying drawings.

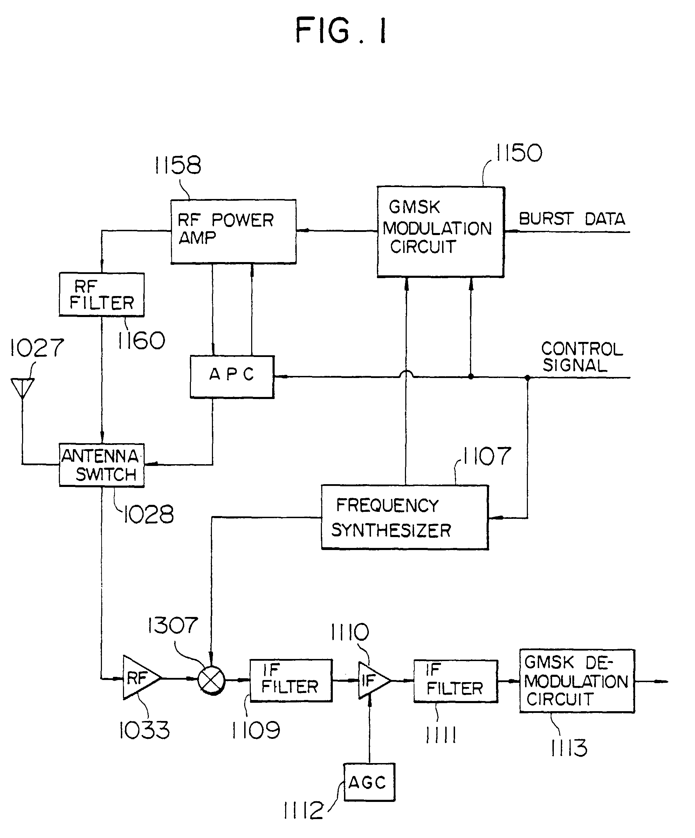

Fig. 1 is a block diagram showing a digital terminal system for European automobile telephone GSM according to the present invention using a surface acoustic wave (SAW) system having a group-type unidirectional transducer.

The crystal filter, the SAW resonator or the like, which cannot secure a required bandwidth, is not usable with the above-mentioned digital terminal system. Also, a multi-electrode SAW filter, which is large in element size and fails to satisfy the group delay characteristic, is neither usable with the system.

In contrast, an application of a surface acoustic wave filter having a group-type unidirectional transducer is able to meet the specification requirements of both the bandwidth and the group delay characteristic, thereby further reducing the insertion loss.

First, explanation will be made about the receiving operation in Fig. 1.

A signal from an antenna 1027 is introduced to a radio frequency amplifier by an antenna switch 1028, and after being mixed with a signal from a frequency synthesizer 1107 by a first mixer 1307, is converted into an intermediate frequency signal of, say, 90 MHz. This signal is filtered by IF filters 1109 and 1111, and is applied to a GSMK demodulator circuit 1113.

In the first embodiment of the present invention, the surface acoustic wave filter having the unidirectional transducer is used for the IF filter 1109, and contributes to an improved receiving characteristic.

1110 designates an IF amplifier, the gain of which is controlled by an AGC (automatic gain control) circuit 1112.

The GSMK demodulator circuit 1113 demodulates the phase-modulated wave produced from the IF filter 1111 into a digital signal and generates a clock playback signal at the same time.

The output of the GSMK demodulator circuit 1113 is shaped into a digital signal of 270.833 kbits/sec by an adaptive equalizer not shown in Fig. 1, followed by being deinterleaved and decoded by a channel decoding circuit, thus being converted into a digital audio signal of 13 kbits/sec, a user data-receiving output signal, a control signal, etc.

In the above-mentioned GSM system, the central frequency $f_0$ of the IF filter 1109 is 90 MHz, and the phase bandwidth thereof is required to be set to about 200 kHz to meet the channel frequency interval of 200 kHz.

Fig. 3 is a diagram showing a surface acoustic wave filter as a model having a unidirectional transducer used for the IF filter 1109.

A sending transducer 1042 and a receiving transducer 1043 are disposed on a substrate 1041 having a piezoelectric property. A signal applied from an electrical signal input terminal 1044 is converted into a mechanical vibration (surface acoustic wave) by the sending transducer 1042, converted to an electrical signal by being propagated to the receiving transducer 1043, and retrieved from the electrical signal output terminal 1045.

The sending transducer 1042 and the receiving transducer 1043 are comprised of three types of electrodes including a Q (sending) electrode 31, an I (reflecting) electrode 32 and a meander electrode 33. Also, each of these electrodes may be generated by aluminum sputtering and photolithography on the substrate 1041 made of quartz, for example.

When voltages vq and vi are applied to the Q electrode 31 and the I electrode 32 with the meander electrode 33 as a reference potential, the portion held between the Q electrode 31 and the meander electrode 33, for instance, is excited, with the result that a surface acoustic wave (SAW) is propagated in both forward and backward directions as shown by arrows. In similar fashion, the portion held between the I electrode 32 and the meander electrode 33 generates a SAW propagated in both forward and backward directions.

As a result, if the SAW portions in backward direction generated by the Q electrode 31 and the I electrode 32 are arranged in such a phase relationship as to offset each other, it is possible to reduce the SAW portions to zero as a whole. Also, the SAWs progressing in the forward direction are added and reinforced by each other in the process. The electrical phase shifter 1046 is for holding the signals from the electrical signal input terminal 1044 in such a phase relationship.

The Q and I electrodes on the receiving transducer 1043 side receive a SAW in forward direction and convert it into a voltage. Since the voltage signals generated by the Q and I electrodes have different phases, they are unified by the electrical phase shifter 1047 and are retrieved from the electrical signal output terminal 1045.

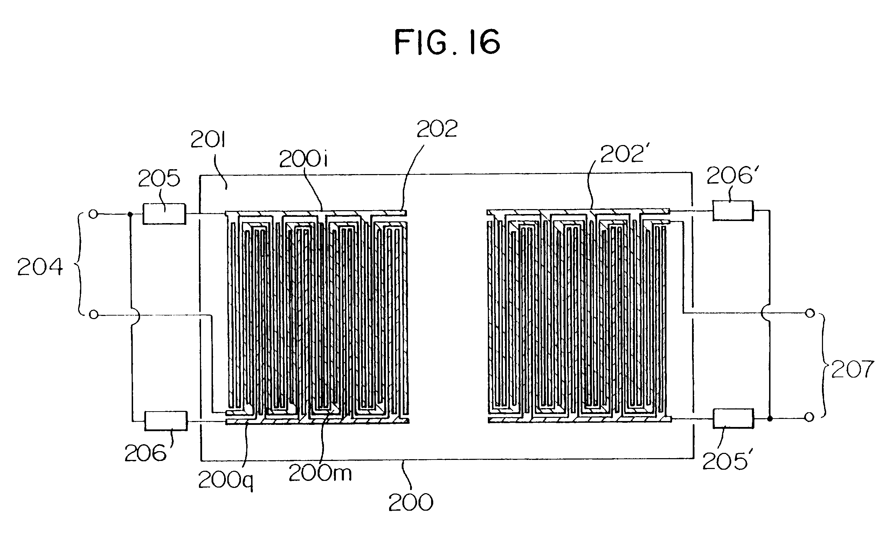

Fig. 15 shows an example of the transmission characteristic of a surface acoustic wave module having the transducer structure shown in Fig. 16 according to the present invention and used as an IF filter. In view of the fact that the loss at a point ±100 kHz from the central frequency 90 MHz is not more than 5 dB, the above-mentioned pass bandwidth of 200 kHz is sufficiently secured.

Also, the group delay deviation within the pass badnwidth was 450 ns in measurement. In the GSM system, the signal transmission rate is 270.833 kbits/ sec, and therefore the transmission time per bit is approximately $3.692\,\mu$secs. Since the 450 ns mentioned above represents about 12% of the figure, the error of digital data caused thereby poses no problem.

Further, the insertion loss of this surface acoustic wave filter is about 2 dB for the central frequency $f_0$ of 90 MHz, and is sufficiently lowered as compared with the loss of the conventional bidirectional surface acoustic wave filter.

The above-mentioned low insertion loss characteristic is based on the fact that perfect undirectivity is given the surface acoustic wave filter.

Fig. 16 is a model plan view of a surface acoustic wave module having a unidirectional transducer according to the present invention using the above-mentioned IF filter 1109.

In Fig. 16, 200 designates a surface acoustic wave element, 201 a quartz substrate ST cut at 42.75°, and 202, 202' sending and receiving interdigital aluminum transducers formed respectively by sputtering and photolithography on the quartz substrate 201. The transducers 202, 202' are configured of a Q electrode 200q, an I electrode 200i and a meander electrode 200m, and forming normal (not weighted) split-connected transducers having m (= 1) pair of Q electrodes and k (= 1) pair of I electrodes within a group. They have a number N (= 100) of groups (with the total electrode pairs of 200), with the geometric phase difference $\phi$ of 240° between electrodes, the opening of 0.6 mm, the aluminum film thickness of about 500 nm and the unit width of electrode of about 4 $\mu$m. The sending transducer 202 and the receiving transducer 202' are formed in such a manner that the forward directions of the surface acoustic waves thereof are opposed to each other in Fig. 16.

Further, in Fig. 16, 204 designates a signal input terminal, and 207 a signal output terminal. Also, 205, 206 and 205', 206' designate electrical phase shifters for the sending transducer 202 and the receiving transducer 202' respectively. The phase shifters 205, 205' are inductors of 1.16 $\mu$H, and 206, 206' inductors of 0.91 $\mu$nH.

The frequency characteristics of the surface acoustic wave module shown in Fig. 16 were measured after taking impedance matching between the measuring instrument and the input terminal 204 and the output terminal 207. Fig. 15 shows the result thereof. The loss was about 2 dB at about the central frequency $f_0$ of 90 MHz.

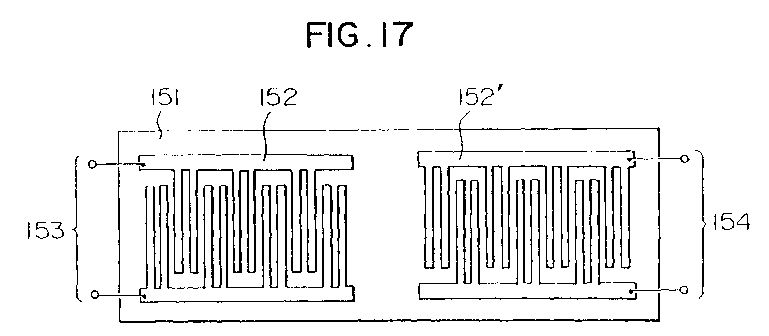

For the purpose of comparison, the frequency transmission characteristic of a surface acoustic wave module using the bidirectional transducer shown in Fig. 17 was measured. In Fig. 17, the substrate 151 of the surface acoustic wave module is made of quartz as in the first embodiment to permit comparison with the first embodiment. Also, the sending transducer 152 and the receiving transducer 152' are constructed of aluminum as a normal-type split-connected transducer with the total number of electrode pairs of 200, the aluminum film thickness of 500 nm and the unit electrode width of about 4 $\mu$m. In Fig. 17, 153 designates a signal input terminal, and 154 a signal output terminal.

In this case of comparison also, the impedance matching was taken between input and output sides, and the loss measured at about the central frequency $f_0$ of 90 MHz. The measurement of about 8 dB was obtained.

Comparison of the first embodiment with a reference shows that the unidirectional surface acoustic wave module according to the first embodiment realizes a low insertion loss of about 6 dB unlike in the bidirectional surface acoustic wave module, and provides a preferable station for a digital communication system. Also, according to the present embodiment, a substantially perfect unidirectivity is realized even in the case where the geometric phase difference $\phi$ is 240°, which is not an odd-numbered multiple of 90°.

The reason why the low insertion loss, i.e., the perfect unidirectivity is realized by the first embodiment will be explained below in detail with reference to the accompanying drawings.

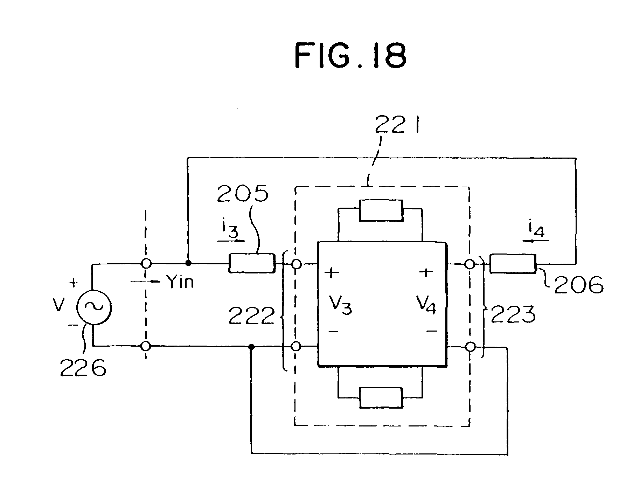

Fig. 18 is a diagram showing the connection between the interdigital transducer and an element making up a phase shifter at the sending (or receiving) end of a surface acoustic wave module according to a first embodiment of the present invention. The two-port network 221 provides an equivalent circuit of the interdigital transducer at sending (or receiving) end. The first port 222 and the second port 223 of this network 221 represent a Q electrode terminal and an I electrode terminal respectively. Also, 205, 206 designate an electrical phase shifter (inductor or capacitor). 226 designates an independent signal source (In the drawing, the internal impedance of the power supply is not shown).

The voltages at the ports 222, 223 and the independent signal source 226 are assumed to be $v_3$, $v_4$ and V, the currents $i_3$, $i_4$ are taken as shown in Fig. 18. Further, the admittances of the elements 205, 206 are represented as $Y_3$, $Y_4$. Then,

$$v_3 = V - i_3/Y_3 \tag{43}$$

$$v_4 = V - i_4/Y_4 \tag{44}$$

Substituting this relation into Equation (31),

$$\begin{bmatrix} v_3 \\ v_4 \end{bmatrix} = \frac{1}{\Delta} \begin{bmatrix} Gi+jBi+Y_4 & -\sqrt{GqGi}(\cos\phi-j(\sin\phi/N)) \\ -\sqrt{GqGi}(\cos\phi-j(\sin\phi/N)) & Gq+jBq+Y_3 \end{bmatrix} \begin{bmatrix} v_3 \\ v_4 \end{bmatrix}$$

$$\cdots\cdots (45)$$

provided, however, that the relation in held

$$\Delta = (Gq+jBq+Y_3)(Gi+jBi+Y_4)-GqGi(\cos\phi-j(\sin\phi/N))^2 \tag{46}$$

In the case where the elements 205, 206 are inductors or capacitors, $Y_3$, $Y_4$ may be expressed as $jB_3$, $jB_4$ using the real numbers $B_3$, $B_4$. Thus,

$$\frac{v_4}{v_3} = \frac{-(\frac{Bq}{B_3}+1) - \frac{\sqrt{GiGq}\sin\phi}{B_4 N} + j(\frac{Gq}{B_3} - \frac{\sqrt{GqGi}}{B_4}\cos\phi)}{-(\frac{Bi}{B_4}+1) - \frac{\sqrt{GiGq}\sin\phi}{B_3 N} + j(\frac{Gi}{B_4} - \frac{\sqrt{GqGi}}{B_3}\cos\phi)}$$

$$(= \xi \exp j\theta) \tag{47}$$

Now, as explained in the section of "Function", if

①

$$\xi = \sqrt{Gi} / \sqrt{Gq} \tag{48}$$

②

$$\theta - \phi = (2n-1)\pi , \qquad \text{(n: Integer)} \qquad (49)$$

and

③

$$\phi \neq n\pi \qquad (50)$$

are established, perfect unidirectivity is obtained. This is equivalent to say that if the real numbers x, y satisfying

$$\frac{(\frac{Bq}{Gq}x + 1) + y\xi \frac{\sin\phi}{N} + j(y\xi\cos\phi - x)}{(\frac{Bi}{Gi}y + 1) + \frac{x\sin\phi}{\xi N} + j(\frac{x}{\xi}\cos\phi - y)} = \xi\exp j\theta$$

$$= -\xi(\cos\phi + j\sin\theta) \qquad (51)$$

are determinable when the geometric phase difference $\phi$ is not an integral multiple of $\pi$ in radians (when $\phi$ is not an integral multiple of 180°), electrical phase shifters 205, 206 realizing perfect unidirectivity are obtainable. In such a case, the susceptance of the phase shifters is given as

$$B_3 = Gq/x \qquad (52)$$

$$B_4 = Gi/y \qquad (53)$$

In fact, x and y satisfying the Equation (51) can be determined in the manner mentioned below. Equation (51) can be rewritten as follows when disintegrated into real and imaginary number sections:
Real number section:

$$\frac{Bq}{Gq} x + 1 + y\xi \frac{\sin\phi}{N} = -\{\cos\phi \, ( \frac{Bi}{Gi} y+1) \, \xi +$$

$$\xi\sin\phi \, y + ( \frac{1}{N} - 1) \, x \, \sin\phi \, \cos\phi\} \qquad (54)$$

Imaginary number section:

$$y\xi\cos\phi - x = -\{\sin\phi \, ( \frac{Bi}{Gi} y + 1) \, \xi + x(\frac{\sin^2\phi}{N} + \cos^2\phi)$$

$$- \xi y\cos\phi\} \qquad (55)$$

Taking these equations as simultaneous ones and solving them for x and y,

$$x = \frac{-N + \xi(N + 1)\frac{Gi}{Bi}\sin\phi}{\frac{Bq}{Gq}N + \frac{\left(N^2 - 1\right)Gi}{N \cdot Bi}\sin^2\phi} \qquad (56)$$

$$y = \frac{-N^2 \sqrt{\frac{Gq}{Gi}} \cdot \frac{Bq}{Gq} - N(N-1)\sin\phi}{N^2 \frac{BiBq}{Gi\sqrt{GqGi}} + \left(N^2 - 1\right)\sqrt{\frac{Gq}{Gi}}\sin\phi} \tag{57}$$

From Equations (52), (53) and (57),

$$B_3 = \frac{BiBqN^2 + \left(N^2 - 1\right)GiGq\sin^2\phi}{-N^2 Bi + \sqrt{GiGq}\, N(N+1)\sin\phi} \tag{58}$$

and

$$B_4 = \frac{BiBqN^2 + \left(N^2 - 1\right)GiGq\sin^2\phi}{-N^2 Bq - \sqrt{GiGq}\, N(N-1)\sin\phi} \tag{59}$$

When $B_3$ and $B_4$ are negative, the inductor may be used as an element, in which case the inductance $L_3$ or $L_4$ thereof (Unit: Henry, H) are given as

$$L_3 = -1/(2\pi f_0 B_3) \tag{60}$$

$$L_4 = -1/(2\pi f_0 B_4) \tag{61}$$

Also, in the case where $B_3$ or $B_4$ is positive, on the other hand, the capacitances $C_3$, $C_4$ (Unit: Farad, F) of a capacitor which may be used, are given as

$$C_3 = B_3/(2\pi f_0) \tag{62}$$

$$C_4 = B_4/(2\pi f_0) \tag{63}$$

Now, according to the first embodiment described above, the admittances of the Q and I electrodes associated with the neighbourhood of the central frequency $f_0$ are about

$$Gq = Gi = 0.24 \text{ (mS)}, \quad Bq = Bi = 1.68 \text{ (mS)}$$

From this, $B_3$, $B_4$ associated with $\phi$ of 240° and N of 100 are determined by Equations (58) and (59) as shown below.

$$B_3 = -1.5 \text{ (mS)}, \qquad B_4 = -1.9 \text{ (mS)}$$

Since both $B_3$ and $B_4$ are negative, the electrical phase shifters 205 (and 205') and 206 (and 206') both make up an inductor, the values $L_3$, $L_4$ of which are given as

$$L_3 = 1.16 \text{ (}\mu\text{H)}, \qquad L_4 = 0.91 \text{ (}\mu\text{H)}$$

By connecting these electrical phase shifters, the surface acoustic wave is propagated in substantially one direction alone in the neighbourhood of the central frequency $F_0$, thereby making it possible to avoid the loss of 3 dB on the sending side and 3 dB on the receiving side which might be caused in a bidirectional surface acoustic wave module, thus minimizing the insertion loss.

By the way, the admittance Yin of the configuration shown in Fig. 18 is computed as follows:

$$Yin = \frac{[y_{33}+y_{44}+j\{(y_{33}-y_{34})y_{44}B_4+(y_{44}-y_{34})y_{34}B_3\}]}{(1+jy_{44}B_4)(1+jY_{33}B_3)+y_{34}^{\,2}B_3B_4} \qquad (64)$$

Provided, however, that

$$y_{33} = Gq + jBq \qquad (65)$$

$$y_{34} = \sqrt{GqGi}\ (\cos\phi - j(\sin\phi)/N) \qquad (66)$$

$$y_{44} = Gi + jBi \qquad (67)$$

According to the first embodiment described above, the admittance is matched to the value given by the equation above thereby to prevent a deteriorated loss which otherwise might be caused by admittance mismatching.

As a result of realizing the unidirectivity by the above-mentioned electrode construction, the excitation or resonance mode of the unrequired wave in the electrodes are suppressed, thereby greatly reducing the group delay deviation, phase distortion and the like, so that a superior characteristic is obtained as an IF filter 1109.

The surface acoustic wave module described in this embodiment is of course applicable also to the IF filter 1111.

By the way, although the width of the I and Q electrodes is set to one eighth the wavelength of the surface acoustic wave at the central frequency, a similar effect is obtained by use of a solid-type interdigital transducer as shown in Fig. 4. In the solid-type inter-digital transducer, the electrode width is set to one fourth the wavelength of the source acoustic wave at the central frequency.

According to the present embodiment, a surface acoustic wave filter having a group-type unidirectional transducer is used for both the sending transducer 202 (1042 in Fig. 3) and the receiving transducer 202' (1043 in Fig. 3). The unidirectional transducer, however, may be used only for one of the sending transducer 202 and the receiving transducer 202'.

Also, in the case where the suppression of frequencies out-of-band is required, the above-mentioned filters are connected in cascade.

Further, even when directivity is not perfect, the effect of low loss is obtained if the surface acoustic wave in forward direction is larger than that in backward direction.

Furthermore, the invention is not limited to the group-type unidirectional transducer, but the effect of low loss, etc. is obtainable in similar fashion by use of a unidirectional transducer utilizing internal reflection or a three-phase unidirectional transducer.

The IF filter 1109 according to the first embodiment may be replaced by a surface acoustic wave module according to the present invention described below.

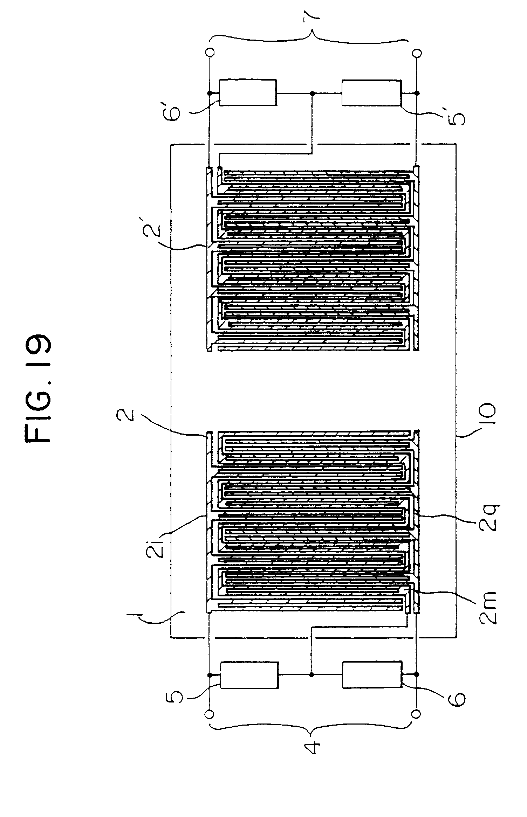

Fig. 19 is a model plan view showing a surface acoustic wave module according to a second embodiment of the present invention.

In Fig. 19, 1 designates a quartz substrate ST cut to 42.75°, and 2, 2' sending and receiving interdigital transducers respectively formed by sputtering and photolithography on the quartz substrate 1. A surface acoustic wave module 10 is configured of these component elements.

The transducers 2 and 2' are configured of a Q electrode 2q, an I electrode 2i and a meander electrode 2m. Also, these transducers 2, 2' provide normal-type (not weighted) split-connected transducers having an m (= 1) pair of Q electrodes and a k pair (= 1) of I electrodes in a group, a number N (= 100) of groups (thus the total number of electrode pairs is 200), a geometric phase difference $\phi$ of 240° between the electrodes, an opening of 5 mm, an aluminum film thickness of 500 nm and a unit electrode width of about 4 μm. By the way, the sending transducer 2 and the receiving transducer 2' on the quartz substrate 1 are formed with the forward directions of the surface acoustic waves thereof opposed to each other in Fig. 19.

Further, in Fig. 19, 4 designates a signal input terminal, and 7 a signal output terminal. Also, 5, 6 and 5', 6' designate electrical phase shifters for the sending transucer 2 and the receiving transducer 2' respectively, the transducers 5, 5' being an inductor of 114 nH, and 6, 6' an inductor of 146 nH.

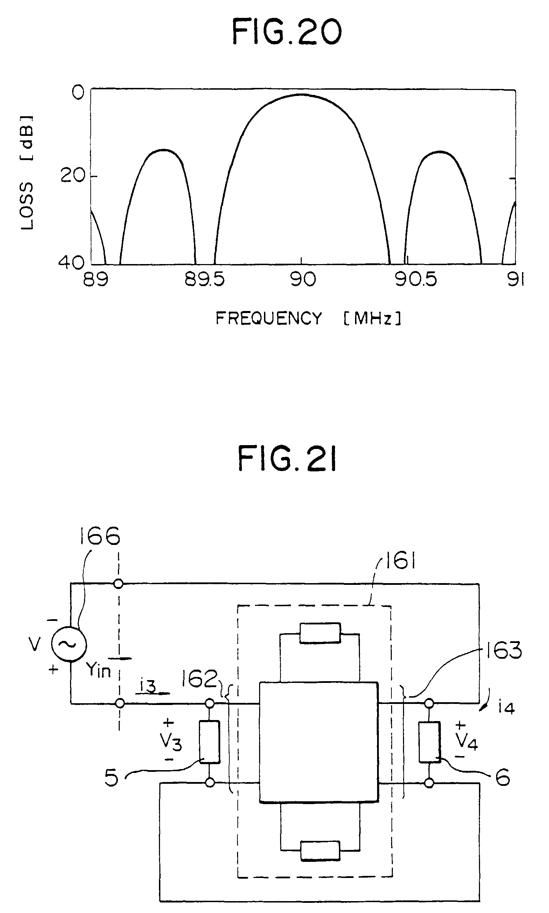

With regard to the surface acoustic wave module shown in Fig. 19, the frequency transmission characteristic from the input terminal 4 to the output terminal 7 was measured after impedance matching taken between the measuring instrument and the input terminal 4 and the output terminal 7. The result is shown in Fig. 20. The loss is about 2 dB in the neighbourhood of the central frequency $f_0$ of 90 MHz, thus indicating substantially the same characteristic as the surface acoustic wave module shown in the first embodiment.

As in the first embodiment, a low loss (perfect unidirectivity) is attained. The reason will be described in detail below with reference to the accompanying drawings.

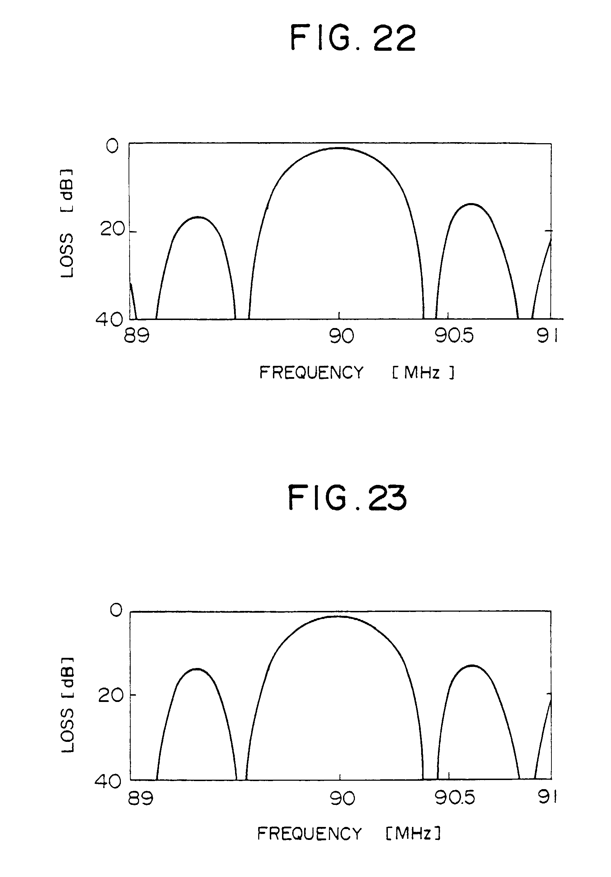

Fig. 21 is a diagram showing the relationship of connection between the interdigital transducer at the sending (or receiving) end of a surface acoustic wave module and an element providing a phase shifter according to a second embodiment of the present invention.

A two-port network 161 represents an equivalent circuit of an interdigital transducer at the sending (or receiving) end, and has a first port 162 and a second port 163 representing Q and I electrode terminals respectively. Also, 5, 6 designate electrical phase shifters (inductances or capacitors). 166 designates an independent signal source (The internal impedance of the power supply is not shown in the drawing).

The ports 162, 163 and the independent signal source 166 are assumed to have a voltage of $v_3$, $v_4$ and V respectively, and currents $i_3$, $i_4$ are assumed to flow as shown in Fig. 21. Further, if the admittances of the elements 5 and 6 are designated by $Y_3$ and $Y_4$ respectively, the circuit equation is given as shown below from Equation (34).

$$\begin{bmatrix} i_3 \\ i_4 \end{bmatrix} = \begin{bmatrix} Gq+Y_3+jBq & \sqrt{GqGi}\{\cos\phi-j(\sin\phi)/N\} \\ \sqrt{GqGi}\{\cos\phi-j(\sin\phi)/N\} & Gi+Y_4+jBi \end{bmatrix} \begin{bmatrix} v_3 \\ v_4 \end{bmatrix}$$

$$\dots\dots (68)$$

In the circuit of Fig. 21, the equations

$$i_3 = -i_4 \qquad\qquad (69)$$

$$V = v_3 - v_4 \qquad\qquad (70)$$

are established. Applying this condition to Equation (68),

$$v_3 = [Gi + Y_4 + jBi + \sqrt{GqGi}\,\{\cos\phi - j(\sin\phi)/N\}]V/D \qquad\qquad (71)$$

$$v_4 = -[Gq + Y_3 + jBq + \sqrt{GqGi}\,\{\cos\phi-j(\sin\phi)/N\}]V/D \qquad\qquad (72)$$

provided, however, that

$$D = Gi + Y_4 + jBi + Gq + Y_3 + jBq + 2\sqrt{GqGi}\{\cos\phi -$$

$$j(\sin\phi)/N\} \qquad\qquad (73)$$

is held. From these facts, the ratio between $v_4$ and $v_3$ is given by the equation below.

$$\frac{v_4}{v_3} = \frac{-[Gq+Y_3+jBq+\sqrt{GqGi}\{\cos\phi-j(\sin\phi)/N\}]}{Gi+Y_4+jBi+\sqrt{GqGi}\{\cos\phi-j(\sin\phi)/N\}} \qquad\qquad (74)$$

In the case where the elements 5, 6 are inductors or capacitors, $Y_3$ is expressed as $jB_3$, and $Y_4$ as $jB_4$ by use of the real numbers $B_3$ and $B_4$ ($B_3$ and $B_4$ are the susceptance portions of the elements), thereby leading to

$$\frac{v_4}{v_3} = \frac{-[Gq+jB_3+jBq+\sqrt{GqGi}\{\cos\phi-j(\sin\phi)/N\}]}{Gi+jB_4+jBi+\sqrt{GqGi}\{\cos\phi-j(\sin\phi)/N\}}$$

$$= \frac{-[\frac{Gq}{Gi}+\frac{\sqrt{Gq}}{\sqrt{Gi}}\cos\phi+j(\frac{B_3}{Gi}+\frac{Bq}{Gi}-\frac{\sqrt{Gq}\sin\phi}{\sqrt{Gi}N})]}{1+\frac{\sqrt{Gq}}{\sqrt{Gi}}\cos\phi+j(\frac{B_4}{Gi}+\frac{Bi}{Gi}-\frac{\sqrt{Gq}\sin\phi}{\sqrt{Gi}N})}$$

$$(= \xi\exp j\theta) \tag{75}$$

Now, as explained in "Function", if

$$\boxed{1} \quad \xi = \sqrt{Gi}/\sqrt{Gq}$$

$$\boxed{2} \quad \theta - \phi = (2n - 1)\pi , \quad (n: \text{Integer})$$

$$\boxed{3} \quad \phi \neq n\pi$$

$$\left.\right\} \quad \dots\dots (76)$$

is established, perfect unidirectivity is obtained. From these facts, it is seen that if the real numbers x and y satisfying

$$\frac{-(\xi^2 + \xi\cos\phi + jy)}{1 + \xi\cos\phi + jx} = \xi\exp(j\theta) = -\xi(\cos\phi + j\sin\phi) \tag{77}$$

can be determined when the geometric phase difference $\phi$ is not an integral multiple of $\pi$ in radians (when $\phi$ is not an integral multiple of 180°), it is possible to obtain an electrical phase shifter realizing perfect unidirectivity. This is because once x and y are determined, the susceptances $B_3$ and $B_4$ of the elements of the phase shifter can be determined in such a way as to satisfy

$$x = \frac{B_4}{Gi} + \frac{Bi}{Gi} - \frac{\sqrt{Gq}}{\sqrt{Gi}}\frac{\sin\phi}{N} \tag{78}$$

and

$$y = \frac{B_3}{Gi} + \frac{Bq}{Gi} - \frac{\sqrt{Gq}}{\sqrt{Gi}}\frac{\sin\phi}{N} \tag{79}$$

and it is easily confirmed that these equations satisfy the conditions described in "Function".

In fact, the values x and y satisfying Equation (77) can be determined in the manner mentioned below. Dividing Equation (77) into real and imaginary number sections and putting them into order,

Real number section:

$$\xi^2 + \xi\cos\phi = \xi(\cos\phi + \xi\cos^2\phi - x\sin\phi) \tag{80}$$

Imaginary number section:

$$y = \xi(\sin\phi + \xi\sin\phi \cos\phi + x\sin\phi) \tag{81}$$

From these equations, x and y are uniquely determined as

$$x = -\xi\sin\phi \tag{82}$$

$$y = \xi\sin\phi \tag{83}$$

From Equations (78) and (82),

$$B_4 = \sqrt{GqGi} \,(1/N-1)\sin\phi - Bi \tag{84}$$

Also, from Equations (79) and (83),

$$B_3 = \sqrt{GqGi} \,(1+\frac{1}{N})\sin\phi - Bq \tag{85}$$

thus making it possible to determine the susceptance of the elements of the electrical phase shifter.

In fact, the element having this susceptance value becomes a capacitance when positive and an inductor when negative as shown by the first embodiment. The element value is computed by the same method as in the first embodiment.

Now, the admittances of the Q and I electrodes in the neighbourhood of the central frequency $f_0$ according to the second embodiment was

$$Gq = Gi = 2.0 \text{ (mS)}, \qquad Bq = Bi = 13.8 \text{ (mS)}$$

From this, $B_3$ and $B_4$ are determined for $\phi$ of 240° and N of 100 from Equations (84) and (85), as shown below.

$$B_3 = -15.6 \text{ (mS)}, \qquad B_4 = -12.1 \text{ (mS)}$$

Since both $B_3$ and $B_4$ are negative, the electrical phase shifters 5 (5 and 5' in Fig. 19) and 6 (6, 6' in Fig. 19) become both inductors, the values $L_3$ and $L_4$ of which are given as

$$L_3 = 114 \text{ (nH)}, \qquad L_4 = 146 \text{ (nH)}$$

By connecting these electrical phase shifters, a surface acoustic wave is propagated substantially only in one direction in the neighbourhood of the central frequency $f_0$, and therefore it is possible to avoid the loss at the sending wave side 3 dB and the receiving wave side 3 dB which is caused in the bidirectional surface acoustic wave module, thereby minimizing the insertion loss.

By the way, the input admittance Yin in the configuration of Fig. 21 is given as

$$Yin = \frac{(Gq+jBq+jB_3)(Gi+jBi+jB_4)-GqGi(\cos\phi - \frac{\sin\phi}{N})^2}{Gq+Gi+j(Bq+Bi+B_3+B_4) + 2\sqrt{GiGq}(\cos\phi - \frac{\sin\phi}{N})} \tag{86}$$

According to the second embodiment described above, the admittance is matched to the value given by this equation at input and output thereby to prevent a deteriorated loss by admittance mismatching.

Further, the IF filter 1109 in the first embodiment may be a surface acoustic wave module according to the present invention described below.

A third embodiment of the present invention will be explained with reference to Fig. 19 again. The surface acoustic wave module according to this embodiment is similar to the second embodiment of the present invention except that the interdigital aluminum electrodes 2, 2' for sending and receiving waves in Fig. 19 are so configured as to have m (= 9) pairs of Q electrodes and a k (= 1) pair of I electrodes in each group, a number N (= 20) of groups, and a geometric phase difference $\phi$ of 270°. Also, electrical phase shifters 5, 6 and 5', 6' for sending and receiving transducers are inductors having an inductance of 824 nH for 5, 5' and 71 nH for 6, 6'.

The frequency transmission characteristic of the surface acoustic wave module according to this embodiment was measured as in the first embodiment. The result is shown in Fig. 22. The loss is about 2 dB in the neighbourhood of the central frequency $f_0$ of 90 MHz, thus realizing a low insertion loss as in the first embodiment.

The reason a low insertion loss can be realized in this way is the same as explained in the second embodiment with reference to Fig. 21. Specifically, the susceptances $B_3$ and $B_4$ at the central frequency $f_0$ of the electrical phase shifters 5, 5' and 6, 6' satisfy Equations (84) and (85), with the result that a surface acoustic wave is propagated substantially in one direction only in the neighbourhood of the central frequency $f_0$, thus making it possible to avoid the loss due to the propagation in the opposite direction (to obtain a sufficient unidirectivity).

According to the above-mentioned third embodiment, the admittances of the Q and I electrodes in the neighbourhood of the central frequency were measured as

$$Gq = 5.83 \text{ (mS)}, \qquad Gi = 0.072 \text{ (mS)}$$

$$Bq = 24.2 \text{ (mS)}, \qquad Bi = 2.42 \text{ (mS)}$$

Assuming that $\phi = 270°$, m = 9, k = 1 and N = 20, $B_3$ and $B_4$ are determined from Equations (84) and (85) as

$$B_3 = -2.14 \text{ (mS)}, \qquad B_4 = -24.9 \text{ (mS)}$$

The inductances determined in such a manner that the susceptances at the central frequency $f_0$ of the electrical phase shifters 5, 5' and 6, 6' are $B_3$ and $B_4$ are 824 nH and 71 nH as described above.

The present embodiment concerns realization of a low insertion loss for different nubmers of pairs between Q and I electrodes.

By the way, a low insertion loss is realizable also when the electrical phase shifters are connected as shown in the configuration of Fig. 16 while maintaining the same electrode construction as in the present embodiment. In such a case, among the electrical phase shifters 205, 206 and 205', 206' for sending and receiving waves in Fig. 16, 205 and 205' are used as inductors of 620 nH, and 206 and 206' as inductors of 90 nH.

These inductance values are based on Equations (58) and (59) indicated in the first embodiment, and a low insertion loss (perfect unidirectivity) is realized in the same manner as in the first embodiment as described above.

Further, the IF filter 1109 in the first embodiment may be a surface acoustic wave module according to the present invention described below.

A fourth embodiment of the present invention will be explained with reference to Fig. 19 again. The surface acoustic wave module according to this embodiment is similar to the second embodiment except that according to the electrode configuration of interdigital transducers 2, 2' for sending and receiving electric waves in this embodiment, the number m of Q electrode pairs and the number k of I electrode pair in a group are nine and one respectively, the number N of group pairs is 20, and the geometric phase difference $\phi$ is 315°. Also, the electrical phase shifters 5, 6 and 5', 6' for sending and receiving transducers respectively provide inductors, the inductances of which are 760 nH for 5, 5' and 72 nH for 6, 6'.

The frequency transmission characteristic of a surface acoustic wave module according to the present embodiment was measured as in the first embodiment, the result of which is shown in Fig. 23. The loss at a point in the neighbourhood of the central frequency $f_0$ of 90 MHz is about 2 dB, thus realizing a low insertion loss as in the first embodiment.

The reason why a low insertion loss is realized in this way was already described when the second embodiment was explained with reference to Fig. 21. Specifically, the susceptances $B_3$ and $B_4$ of the electrical phase shifters 5, 5' and 6, 6' at the central frequency $f_0$ satisfy Equations (84) and (85), with the result that the surface acoustic wave is propagated only in one direction substantially in the neighbourhood of the central frequency, thereby avoiding the loss by the propagation in the opposite direction (assuring a sufficient unidirectivity).

In the fourth embodiment described above, the admittances of the Q and I electrodes in the neighbourhood of the central frequency $f_0$ were measured as follows:

$$Gq = 5.83 \text{ (mS)}, \qquad Gi = 0.072 \text{ (mS)}$$

$$Bq = 24.2 \text{ (mS)}, \qquad Bi = 2.42 \text{ (mS)}$$

$B_3$ and $B_4$ for $\phi$ of 315°, m of 9, k of 1 and N of 20 are determined from Equations (84) and (85) as shown below.

$$B_3 = -2.33 \text{ (mS)}, \qquad B_4 = -24.7 \text{ (mS)}$$

The inductances of the electrical phase shifters 5, 5' and 6, 6' determined in such a manner that the susceptances at the central frequency $f_0$ are $B_3$ and $B_4$, are 760 nH and 72 nH respectively as described above.

The present embodiment concerns realization of a low insertion loss in the case where the Q and I electrodes have different numbers of pairs and the geometric phase difference $\phi$ is other than an odd-numbered multiple of 90°.

By the way, a low insertion loss is realized also similarly when the electrical phase shifters are connected as shown in Fig. 16 while an electrode configuration similar to that of the present embodiment is employed. In such a case, among the electrical phase shifters 205, 206 and 205', 206' of the sending and receiving electrodes shown in Fig. 16, 205, 205' provide inductors of 627 nH, and 206, 206' inductors of 85 nH.

These inductance values are based on Equations (58) and (59) shown in the first embodiment, and the reason why a low insertion loss (perfect unidirectivity) is realizable is described in the first embodiment as explained above.

As seen from above, according to the technique of the present invention described above, a low insertion loss is realized without regard to the number of pairs of Q or I electrodes, the number of groups or the geometric phase difference (not a multiple of 180°).

Next, explanation will be made about an embodiment of the present inventin using a surface acoustic wave module having a unidirectional transducer described for an RF filter 1160 of the transmission system shown in Fig. 1 as a surface acoustic wave filter.

In Fig. 1, an analog signal and a user data are subjected to convolution coding and interleaving processes after conversion into a 13-bit digital signal by a circuit portion not shown in the diagram, and thus are compressed from the transmission rates of 22.8 kbits/sec and 11.8 kbits/sec into a burst data of 270.833 kbits/sec respectively.

This burst data is converted into a radio frequency signal by the GMSK modulation circuit shown in Fig. 1, and is radiated by way of the antenna 1027 through the RF power amplifier 1158, the RF filter 1160 and the antenna switch 1028.

According to the present invention, a surface acoustic wave module having a unidirectional transducer is used for the RF filter 1160.

The RF filter 1160 has the same structure as that shown in Fig. 16 and is such that an interdigital sending transducer 202 and an interdigital receiving transducer 202' of an aluminum-titanium alloy are formed by sputtering and dry etching technique on a quartz substrate ST cut to 42.75°. These electrodes are configured as a normal (not weighted) split-connected electrode having a number m (= 1) of pair of Q electrodes and a number k (= 1) of pair of I electrodes in a group, a number N (= 12) (Thus the total number of pairs of electrodes is 24) of groups, a geometric phase difference $\phi$ of 270° between electrodes, an opening of 1 mm, the thickness of 100 nm of the aluminum-titanium alloy and the unit electrode width of about 0.4 $\mu$m. The two electrodes are formed in such a manner that the forward directions of the surface acoustic waves thereof are opposed to each other.

By the way, the susceptances of the electrical phase shfiters 205, 205' and 206, 206' shown in Fig. 16 are determined by a technique similar to that shown in the first embodiment.

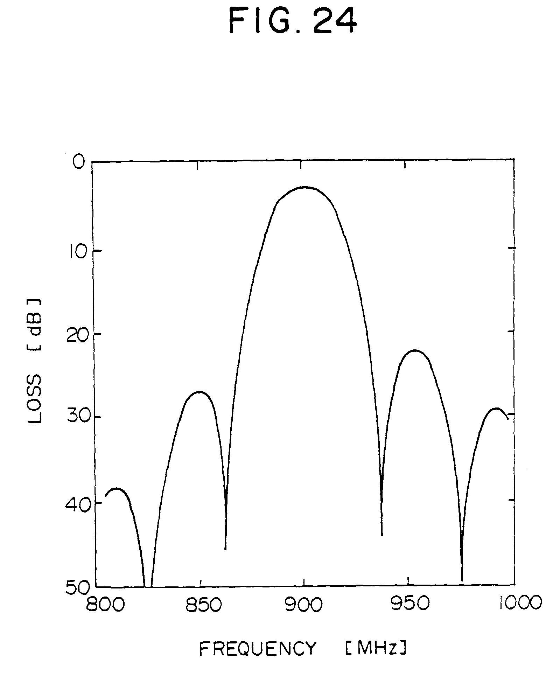

Fig. 24 shows the result of measuring the frequency characteristic of a surface acoustic wave module having a unidirectional transducer for the RF filter 1160. The input and output terminals are matched in impedance with the measuring circuit.

From the foregoing, it is seen that the bandwidth of 890 to 915 MHz of the transmitting frequency required for the GMS system is secured and that the ripple and loss in the pass bandwidth are sufficiently small. As a result, the amplitude distortion or phase distortion of the transmission signal is negligibly small.

Also, the above-mentioned loss was about 3 dB in the neighbourhood of the central frequency $f_0$ of 900 MHz. This is because as described with reference to Embodiment 1, the phase difference and the amplitude ratio between the Q and I electrodes are set properly by the electrical phase shifters, and therefore the surface acoustic wave is propagated only in forward direction but not in backward direction. When a bidirectional surface acoustic wave filter is used, in contrast, a minimum of 3 dB of loss is caused each at the sending and receiving sides. Another problem posed in this case is that an amplifier circuit is required to compensate for the loss.

By the way, the surface acoustic wave filter described above may be used for the receiving RF filter as well as for the sending one.

According to Embodiments 1 to 5 described above, a unidirectional transducer is used for both the sending and receiving transducers. It is of course possible, however, to apply the present invention to only one of the sending and receiving transducers.

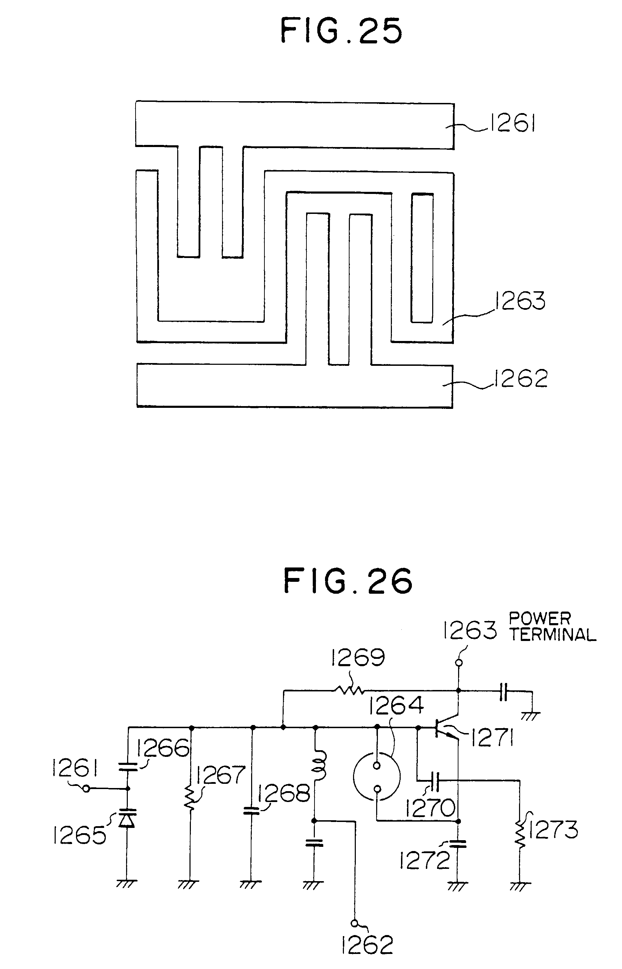

Although a normal-type transducer having a uniform opening width was used in Embodiments 1 to 5 above, the present invention is not limited to such a transducer, but a transducer as shown in Fig. 25 as weighted appropriately may be used with equal effect. In Fig. 25, 1261, 1262 designate I and Q electrodes respectively, and 1263 a meander electrode. Since the opening is weighted, the I electrode 1261 and the Q electrode 1262 have different opening lengths, and hence different conductances of Gi and Gq respectively. Also in this case, a low insertion loss is realized as in the aforementioned embodiment.

Also, any material having a piezoelectric property such as $LiTaO_3$ as well as quartz or $LiNbO_3$ may be used for the piezoelectric substrate. Further, the material of the electrodes is not limited to aluminum but may be an aluminum-titanium alloy or an aluminum-chromium alloy.

A frequncy synthesizer 1107 shown in Fig. 1 includes a voltage-controlled oscillator (VCO) as shown in Fig. 26.

Fig. 26 shows a Colpitts-type oscillator circuit in basic terms. A surface acoustic wave element 1264 is connected between the base and emitter of a transistor 1271. The capacitance value of a variable-capacitance diode 1265 is changed by a control voltage applied to a control voltage terminal 1261 thereby to produce a variable frequency signal from an output terminal 1262.

Conventional systems use an LC resonance circuit including an inductor, a capacitor and the like in place of the surface acoustic wave element 1264. The surface acoustic wave element has a Q value larger than a resonance circuit including an inductor and a capacitor. The phase noise level providing a phase fluctuation of the VCO output, therefore, is reduced. Also, since the oscillation resistance is improved as compared with the above-mentioned resonance circuit including an inductor and a capacitor, the VCO output frequency is not changed by oscillation, thereby further widening the variable frequency range.

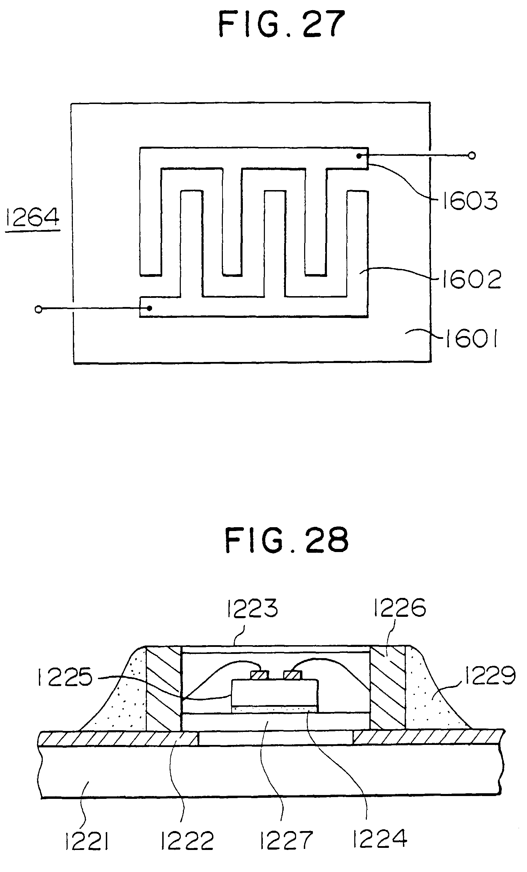

Fig. 27 is a model diagram showing the shape of an electrode of the surface acoustic wave element 1264 described above. Interidigtal transducers 1602 and 1603 having an electrode width of about 1 μm are formed by sputtering and photolithography on an ST cut quartz sustrate 1601.

In the case where the capacitors 1266, 1268, 1270 and 1272 shown in Fig. 26 are adapted to have capacitances of 6 pF, 3 pF, 12 pF and 12 pF respectively, and resistors 1267, 1269 and 1273 have the resistance values of 3.9 kΩ, 5.6 kΩ and 220 Ω respectively, then an oscillation output of about 860 MHz to 960 MHz could be stably obtained against a control voltage of 0 to 10 V.

Next, explanation will be made about an embodiment of the present invention in which the surface acoustic wave element is housed in a preferable surface-mount type package.

Fig. 28 is a sectional view of the surface-mount type package mentioned above. A package 1223 housing a surface acoustic wave element is directly soldered on a print pattern 1222 on a printed board 1221.

A surface acoustic wave element 1225 except for a phase shifter is fixed by adhesive 1224 such as silver paste on the package base 1227, on the side of which there is backed a terminal 1226. This terminal 1226 and the print pattern 1222 are fixedly connected by solder 1229. Also, the electrodes of the surface acoustic wave element are connected to the terminal 1226 by metal wire.

Since the package lacks a pin, no hole is required of the printed board and the terminal pitch is reduced, thereby increasing the package density.

Further, the stray inductance at the connector with the substrate is reduced. At the same time, the value of this stray inductance remains unchanged, thereby leading to the advantage that the performance variation of the communication ports can be reduced.

Each of the embodiments described above is applicable with equal effect to the mobile digital station used with a system other than European digital automobile telephone GSM.

The cordless telephone CT2 system of the Britain, for example, has a channel frequency interval of 100 kHz, a transmission system of FDMA (frequency division multiple access), a modulation system GMSK of 72 kbits/sec, and an audio coding system ADPCM or 32 kbits/sec.

Also, the DECT under study in Europe as a standard has a channel frequency interval of 1.7 MHz, a transmission system multiple TDMA of 12 channels, a modulation system GMSK of 1152 kbits/sect and an audio coding system ADPCM of 32 kbits/sect.

The present invention is applicable with equal effect to the mobile station used for each of these systems.

By the way, groups each configured of an I electrode (reflector) having k pairs per period and a Q electrode (sending transducer) having m pairs per period are repeatedly arranged in the number of N. The pass bandwidth is inversely proportional to the total number N of pairs (k + m) of the electrodes and is determined by N, k, m, etc., and therefore the total number of electrode pairs is reduced with the widening of pass bandwidth for an increased miniaturization.

An embodiment of a surface acoustic wave module used as an IF filter for DECT will be explained below.

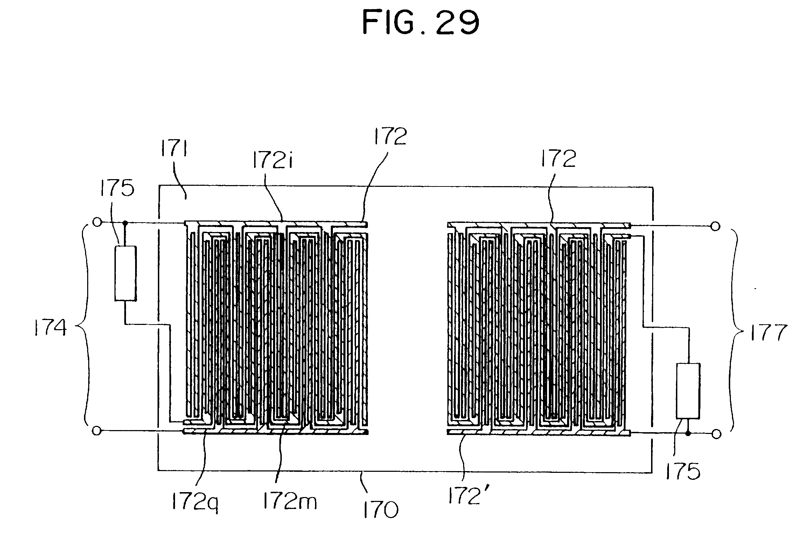

Fig. 29 is a model diagram showing a surface acoustic wave module according to an embodiment of the present invention.

In Fig. 29, 170 designates a surface acoustic wave element, 171 a LiNbO$_3$ (lithium niobate) single crystal substrate cut along a Y axis rotating by 128° and propagated along X axis. 172, 172' designate interdigital aluminum transducers for sending and receiving electric waves, formed by sputtering and photolithography on an LiNbO$_3$ substrate 171. The electrodes 172 and 172' are so configured as to include a Q electrode 172q, an I electrode 172i and a meander electrode 172m making up a normal-type split-connected transducer, where the number m of pair of Q electrodes in a group is 1, the number k of pair of I electrodes is also 1, the number N of groups is 20 (thus the total number of electrode pairs is 40), the geometric phase difference $\phi$ between electrodes is 412°, the opening is 0.6 mm, the aluminum film thickness is 500 nm and the unit electrode width is about 5 $\mu$m. By the way, the sending transducer 172 and the receiving transducer 172' on the LiNbO$_3$ substrate 171 are arranged in such a manner that the forward directions of the surface acoustic waves thereof coincide with each other in Fig. 29.

Further, in Fig. 29, 174 designates an input terminal, and 177 an output terminal. 175, 175' designate an electrical phase shifter made up of an inductor of 193 nH.

The frequency characteristic of this surface acoustic wave module was measured as in the first embodiment, the result of which is shown in Fig. 30. In spite of the fact that the loss is about 2 dB at around the central frequency $f_0$ of 90 MHz and there is only one element as a phase shifter, a low loss (perfect unidirectivity) is attained as in the first embodiment. The reason for this is described below.

Fig. 31 is a configuration diagram showing the connection between a transducer at the sending (or receiving) end of the surface acoustic wave module and an element providing a phase shifter according to the present invention. This embodiment is configured of elements in the number smaller by one than in the configuration of the second embodiment.

191 designates an equivalent circuit of an interdigital transducer at the receiving (or sending) end, and has a first port 192 and a second port 193 representing a Q electrode terminal and an I electrode terminal respectively. 175 designates an electrical phase shifter (inductor or capacitor). 196 designates an independent signal source.

The voltages at the ports 192, 193 and the independent signal source 196 are assumed to be $v_3$, $v_4$ and V respectively, and currents $i_3$ and $i_4$ are assumed to flow as shown in Fig. 31. Further, the admittance of the element 184 making up an electrical phase shifter is designated by $Y_3$. In the case where the electrical phase shifter 175 is an inductor or capacitor, $Y_3$ may be expressed as $jB_3$ using a real number $B_3$ ($B_3$ represents the susceptance of the element).

Now, assume that the interdigital transducer under consideration satisfies the relation that (left side of Equation (84)) = 0, that is,

$$\sin\phi = \frac{Bi}{\sqrt{GiGq}(1/N-1)} \tag{87}$$

By employing the electrical phase shifter 175 having a susceptance $B_3$ given by Equation (85) in the description of the second embodiment, perfect unidirectivity is realizable even with a single electrical phase shifter.

A measurement of the admittance of the Q and I electrodes in this embodiment shows that

$$Gq = Gi = 6.8 \text{ (mS)}, \qquad Bq = Bi = 3.8 \text{ (mS)}$$

at the central frequency $f_0$ of 90 MHz, thereby substantially satisfying Equation (87) when $\phi$ = 312° and N = 20. As a consequence, perfect unidirectivity is realized with a single electrical phase shifter. The design value of this electrical phase shifter 175 is given as $B_3$ = -9.1 (mS), i.e., $L_3$ 193 (nH) from Equation (85). By connecting this electrical phase shifter 175, the surface acoustic wave is propagated only in one direction substantially at around the central frequency. Thus the losses of 3 dB at the sending end and 3 dB at the receiving end are avoided unlike in a bidirectional surface acoustic wave module, thereby minimizing the insertion loss.

By the way, although the embodiment under consideration is configured to connect a phase shifter to the Q electrode side, it is also possible to realize perfect unidirectivity by connecting a phase shifter on the I electrode side. In such a case, to the extent that the relation of (left side of Equation (85)) = 0, that is,

$$\sin\phi = \frac{Bq}{\sqrt{GiGq}(1/N+1)} \tag{88}$$

is satisfied instead of Equation (87), perfect unidirectivity can be realized by employing a single electrical phase shifter having the susceptance of $B_4$ given by Equation (84) as described in the first embodiment. It of course depends on the sign of susceptance whether an inductor or a capacitor is to be employed, as explained in detail with reference to the first embodiment.

By the way, the admittance Yin as computed of the configuration shown in Fig. 31 is given as

$$Yin = \frac{(Gq+jBq+jB_3)(Gi+jBi)-GqGi(\cos\phi - \frac{\sin\phi}{N})^2}{Gq+Gi+j(Bq+Bi+B_3) + 2\sqrt{GiGq}(\cos\phi - \frac{\sin\phi}{N})} \tag{89}$$

According to the present embodiment, impedance is matched to this value.

According to the present invention, there is provided a stable station for digital communication system comprising a low-loss filter having a wide pass-band characteristic as well as a superior phase characteristic, group delay characteristic, etc.

Further, the phase noise level of a voltage-controlled oscillator used with the station for digital communication system is reduced while at the same time improving the oscillation resistance thereof.

Furthermore, there is provided a compact station for digital communication system.

Also, according to the present invention, as explained above, there is provided a surface acoustic wave module in which a transducer is not required to be configured in a specific way when the geometric phase difference between transducers is other than an integral multiple of $\pi$, and the surface acoustic wave can be propagated exactly in one direction with a reduced insertion loss.

Further, according to the present invention, there is provided a surface acoustic wave module in which a completely unidirectional propagation of a surface acoustic wave is made possible by an electrical phase shifter with a single component element, thereby reducing the insertion loss and securing the advantages of higher productivity and lower cost.

## Claims

1.  A surface acoustic wave module, comprising:

    a surface acoustic wave element having a first interdigital transducer as a sending transducer (2, 202, 1042) and a second interdigital transducer as a receiving transducer (2', 202', 1043) of the surface acoustic wave on a piezoelectric substrate (10, 201, 1041), at least one of the transducers being a unidirectional transducer including a combination of Q electrodes as reflecting electrodes and I electrodes as sending electrodes or a group-type unidirectional transducer having a plurality of groups of such combinations, and

    an electrical phase shifter (5, 5', 6, 6', 175, 205, 205', 206, 206', 1046, 1047) for applying a voltage having an electrical phase difference θ and a voltage ratio of 1:ξ to the Q electrodes and the I electrodes,

    **characterized in** that
    the Q electrodes, the I electrodes and the electrical phase shifter have a relation expressed as

    $$\xi = \sqrt{Gq/Gi}$$

    and

    $$\theta - \phi = (2n-1)\pi \text{ or } \theta + \phi = (2n-1)\pi$$

    where n is an integer and $\phi \neq n\pi$
    wherein Gq is the conductance of the Q electrode, Gi the conductance of the I electrode, ξ the voltage ratio, $\phi$ the geometric phase difference and θ the electrical phase difference.

2.  A surface acoustic wave module according to claim 1, characterized in that the electrical phase difference 8 is set to a value other than $\pi/4$ radians.

3. A surface acoustic wave module according to claim 1 or 2, characterized in that the Q electrode and the I electrode have conductances different from each other.

4. A surface acoustic wave module according to claim 1, characterized in that

at least one of the transducers is a unidirectional transducer having a combination of m pairs of Q electrodes and k pairs of I electrodes with a non-apodizing interdigital transducer or a group-type unidirectional transducer having a plurality of such groups of combinations, and

the Q electrode pairs, the I electrode pairs and the electrical phase shifter have a relation expressed as

$$\xi = m/k$$

and

$$\theta - \phi = (2n-1)\pi \text{ or } \theta + \phi = (2n-1)\pi$$

where n is an integer and $\phi \neq n\pi$
wherein m is the number of Q electrode pairs, k the number of I electrode pairs, $\xi$ the voltage ratio, $\phi$ the geometric phase difference and $\theta$ the electrical phase difference.

5. A surface acoustic wave module according to claim 1, characterized in that

at least one of the transducers is a group-type unidirectional transducer having N groups of combinations,

the Q electrodes and/or the I electrodes are connected in parallel to an electric phase shifter (5, 5', 6, 6', 175) and in series with each other,

the conductance of the Q electrode is Gq, the conductance of the I electrode is Gi, the susceptance of the Q electrode is Bq, and the susceptance of the I electrode is Bi,

the susceptance of the electric phase shifter (5, 5', 175) connected to the Q electrode is given as

$$\sqrt{GqGi}\,(1 + 1/N)\sin\phi - Bq$$

and the susceptance of the electric phase shifter (6, 6') connected to the I electrode is given as

$$-\sqrt{GqGi}\,(1 - 1/N)\sin\phi - Bi$$

6. A surface acoustic wave module according to claim 5, characterized in that

the conductance Gq of the Q electrode, the conductance Gi of the I electrode, the susceptance Bq of the Q electrode, the geometric phase difference $\phi$ and the number N of groups have a relation given as

$$\sqrt{GqGi}\,(1 + 1/N)\sin\phi - Bq = 0$$

and no electric phase shifter is connected with the Q electrodes.

7. A surface acoustic wave module according to claim 5, characterized in that

the the conductance Gq of the Q electrode, the conductance Gi of the I electrode, the susceptance Bq of the I electrode, the geometric phase difference $\phi$ and the number N of groups have a relation given as

EP 0 473 096 B1

$$- \sqrt{GqGi}\,(1 - 1/N)\sin\phi\, -Bi = 0$$

and no electric phase shifter is connected to the I electrodes.

8. A surface acoustic wave module according to claim 1, characterized in that

at least one of the transducers is a group-type unidirectional transducer with N groups of combinations,

the Q electrodes and/or the I electrodes are connected in series with an electric phase shifter (205, 205', 206, 206') on the one hand and in parallel to each other on the other hand through the electric phase shifter,

the conductance of the Q electrode is Gq, the conductance of the I electrode is Gi, the susceptance of the Q electrode is Bq, and the susceptance of the I electrode is Bi, and

the susceptance of the electric phase shifter (205, 205') connected to the Q electrodes is given as

$$\frac{BiBqN^2+(N^2-1)\,GiGq\sin^2\phi}{-N^2Bi+\sqrt{GqGi}\,N\,(N+1)\,\sin\phi}$$

the susceptance of the electric phase shifter (206, 206') connected to the I electrodes is given as

$$\frac{BiBqN^2+(N^2-1)\,GqGi\sin^2\phi}{-N^2Bq-\sqrt{GqGi}\,N\,(N-1)\,\sin\phi}$$

9. A surface acoustic wave module according to claim 8, characterized in that

the conductance Gq of the Q electrode, the conductance Gi of the I electrode, the susceptance Bi of the I electrode, the geometric phase difference $\phi$ and the number N of groups have a relation given as

$$-N^2Bi- \sqrt{GqGi}\,N(N+1)\sin\phi=0$$

and no electric phase shifter is connected to the Q electrodes.

10. A surface acoustic wave module according to claim 8, characterized in that

the conductance Gq of the Q electrode, the conductance Gi of the I electrode, the susceptance Bq of the Q electrode, the geometric phase difference $\phi$ and the number N of groups have a relation given as

$$-N^2Bq- \sqrt{GqGi}\,N(N-1)\sin\phi=0$$

and no electric phase shifter is connected to the I electrodes.

11. A station for a digital communication system characterized in that it includes a surface acoustic wave module according to any one of claims 1 to 10 used for radio frequency filtering or intermediate frequency filtering.

**Patentansprüche**

1. Oberflächenakustikwellen-Modul, aufweisend:

ein Oberflächenakustikwellen-Element mit einem ersten Interdigital-Wandler als sendender Wandler (2, 202, 1042) und einem zweiten Interdigital-Wandler als empfangender Wandler (2', 202', 1043) der Oberflächenakustikwelle auf einem piezo-elektrischen Substrat (10, 201, 1041), wobei mindestens einer der Wandler ein unidirektionaler Wandler mit einer Kombination von Q-Elektroden als reflektierende Elektroden und I-Elektroden als sendende Elektroden oder ein Gruppentyp-unidirektionaler-Wandler mit einer Mehrzahl von Gruppen von solchen Kombinationen ist und

einem elektrischen Phasenschieber (5, 5', 6, 6', 175, 205, 205', 206, 206', 1046, 1047) zum Anlegen einer Spannung, die eine elektrische Phasendifferenz $\theta$ und ein Spannungsverhältnis von $1:\xi$ an die Q-Elektroden und die I-Elektroden aufweist,

**dadurch gekennzeichnet**, daß
die Q-Elektroden, die I-Elektroden und der elektrische Phasenschieber eine Relation erfüllen, die ausgedrückt wird:

$$\xi = \sqrt{Gq/Gi}$$

und

$$\theta - \phi = (2n - 1)\pi \text{ oder } \theta + \phi = (2n - 1)\pi$$

wobei n eine ganze Zahl ist und $\phi \neq n\pi$,
wobei Gq die Konduktanz der Q-Elektrode, Gi die Konduktanz der I-Elektrode, $\xi$ das Spannungsverhältnis, $\phi$ die geometrische Phasendifferenz und $\theta$ die elektrische Phasendifferenz ist.

2. Oberflächenakustikwellen-Modul gemäß Anspruch 1, dadurch gekennzeichnet, daß die elektrische Phasendifferenz $\theta$ auf einen Wert ungleich $\pi/4$ Radian gesetzt ist.

3. Oberflächenakustikwellen-Modul gemäß Anspruch 1 oder 2, dadurch gekennzeichnet, daß die Q-Elektrode und die I-Elektrode voneinander unterschiedliche Konduktanzen besitzen.

4. Oberflächenakustikwellen-Modul gemäß Anspruch 1, dadurch gekennzeichnet, daß

mindestens einer der Wandler ein unidirektionaler Wandler ist mit einer Kombination von m Paaren von Q-Elektroden und k Paaren von I-Elektroden mit einem nicht-apodisierten Interdigital-Wandler oder ein Gruppentyp-unidirektionaler-Wandler mit einer Mehrzahl von solchen Gruppen von Kombinationen ist, und

die Q-Elektrodenpaare, die I-Elektrodenpaare und der elektrische Phasenschieber eine Relation erfüllen, die ausgedrückt wird als:

$$\xi = m/k$$

und

$$\theta - \phi = (2n - 1)\pi \text{ oder } \theta + \phi = (2n - 1)\pi$$

wobei n eine ganze Zahl ist und $\phi \neq n\pi$
wobei m die Anzahl von Q-Elektrodenpaaren, k die Anzahl von I-Elektrodenpaaren, $\xi$ das Spannungsverhältnis, $\phi$ die geometrische Phasendifferenz und $\theta$ die elektrische Phasendifferenz ist.

5. Oberflächenakustikwellen-Modul gemäß Anspruch 1, dadurch gekennzeichnet, daß

mindestens einer der Wandler ein Gruppentyp-unidirektionaler-Wandler mit N Gruppen von Kombinationen ist,

die Q-Elektroden und/oder die I-Elektroden parallel zu einem elektrischen Phasenschieber (5, 5', 6, 6', 175) und in Reihe miteinander verbunden sind,

die Konduktanz der Q-Elektroden Gq ist, die Konduktanz der I-Elektroden Gi ist, die Suszeptanz der Q-Elektrode Bq und die Suszeptanz der I-Elektrode Bi ist,

die Suszeptanz des elektrischen Phasenschiebers (5, 5', 175), der mit der Q-Elektrode verbunden ist, gegeben ist durch

$$\sqrt{GqGi}\,(1 + 1/N)\sin\phi\text{-}Bq$$

und die Suszeptanz des elektrischen Phasenschiebers (6, 6'), der mit der I-Elektrode verbunden ist, gegeben ist durch

$$-\sqrt{GqGi}\,(1 - 1/N)\sin\phi\text{-}Bi$$

6. Oberflächenakustikwellen-Modul gemäß Anspruch 5, dadurch gekennzeichnet, daß

die Konduktanz Gq der Q-Elektrode, die Konduktanz Gi der I-Elektrode, die Suszeptanz Bq der Q-Elektrode, die geometrische Phasendifferenz $\phi$ und die Anzahl N von Gruppen eine Relation erfüllen, die gegeben ist durch

$$\sqrt{GqGi}\,(1 + 1/N)\sin\phi\text{-}Bq=0$$

und kein elektrischer Phasenschieber mit den Q-Elektroden verbunden ist.

7. Oberflächenakustikwellen-Modul gemäß Anspruch 5, dadurch gekennzeichnet, daß

die Konduktanz Gq der Q-Elektrode, die Konduktanz Gi der I-Elektrode, die Suszeptanz Bi der I-Elektrode, die geometrische Phasendifferenz $\phi$ und die Anzahl N von Gruppen eine Relation erfüllen, die gegeben ist durch

$$-\sqrt{GqGi}\,(1 - 1/N)\sin\phi\text{-}Bi=0$$

und kein elektrischer Phasenschieber mit den I-Elektroden verbunden ist.

8. Oberflächenakustikwellen-Modul gemäß Anspruch 1, dadurch gekennzeichnet, daß

mindestens einer der Wandler ein Gruppentyp-unidirektionaler-Wandler mit N Gruppen von Kombinationen ist,

die Q-Elektroden und/oder die I-Elektroden in Serie mit einem elektrischen Phasenschieber (205, 205', 206, 206') auf der einen Seite und parallel zueinander auf der anderen Seite durch den elektrischen Phasenschieber verbunden sind,

die Konduktanz der Q-Elektrode Gq ist, die Konduktanz der I-Elektrode Gi ist, die Suszeptanz der Q-Elektrode Bq ist und die Suszeptanz der I-Elektrode Bi ist und

die Suszeptanz des elektrischen Phasenschiebers (205, 205'), der mit den Q-Elektroden verbunden ist, gegeben ist durch

$$\frac{BiBqN^2+(N^2-1)\,GiGq\sin^2\phi}{-N^2Bi+\sqrt{GqGi}N\,(N+1)\,\sin\phi}$$

die Suszeptanz des elektrischen Phasenschiebers (206, 206'), der mit den I-Elektroden verbunden ist, gegeben ist durch

$$\frac{BiBqN^2+(N^2-1)GqGi\sin^2\phi}{-N^2Bq-\sqrt{GqGi}N(N-1)\sin\phi}$$

9.  Oberflächenakustikwellen-Modul gemäß Anspruch 8, dadurch gekennzeichnet, daß

die Konduktanz Gq der Q-Elektrode, die Konduktanz Gi der I-Elektrode, die Suszeptanz Bi der I-Elektrode, die geometrische Phasendifferenz $\phi$ und die Anzahl N von Gruppen eine Relation erfüllen, die gegeben ist durch

$$-N^2Bi-\sqrt{GqGi}\ N(N+1)\sin\phi=0$$

und kein elektrischer Phasenschieber mit den Q-Elektroden verbunden ist.

10. Oberflächenakustikwellen-Modul gemäß Anspruch 8, dadurch gekennzeichnet, daß

die Konduktanz Gq der Q-Elektrode, die Konduktanz Gi der I-Elektrode, die Suszeptanz Bq der Q-Elektrode, die geometrische Phasendifferenz $\phi$ und die Anzahl N von Gruppen eine Relation erfüllen, die gegeben ist durch

$$-N^2Bq-\sqrt{GqGi}\ N(N-1)\sin\phi=0$$

und kein elektrischer Phasenschieber mit den I-Elektroden verbunden ist.

11. Station für ein digitales Kommunikationssystem, dadurch gekennzeichnet, daß sie ein Oberflächenakustikwellen-Modul gemäß einem der Ansprüche 1 - 10 aufweist zur Benutzung für Radiofrequenzfilterung oder Zwischenfrequenzfilterung.

**Revendications**

1.  Module à ondes acoustiques de surface comprenant :

un élément à ondes acoustiques de surface ayant un premier transducteur interdigité en tant que transducteur d'émission (2, 202, 1042) et un deuxième transducteur interdigité en tant que transducteur de réception (2', 202', 1043) de l'onde acoustique de surface sur un substrat piézoélectrique (10, 201, 1041), au moins un des transducteurs étant un transducteur unidirectionnel incluant une combinaison d'électrodes Q en tant qu'électrodes de réflexion et d'électrodes I en tant qu'électrodes d'émission ou un transducteur unidirectionnel du type groupe ayant une pluralité de groupes de telles combinaisons, et

un déphaseur électrique (5, 5', 6, 6', 175, 205, 205', 206, 206', 1046, 1047) pour appliquer une tension ayant une différence de phase électrique $\theta$ et un rapport de tension de 1:$\xi$ par rapport aux électrodes Q et aux électrodes I,

caractérisé en ce que
les électrodes Q, les électrodes I et le déphaseur électrique ont une relation exprimée par :

$$\xi = \sqrt{Gq/Gi}$$

et

$$\theta - \phi = (2n - 1)\pi \text{ ou } \theta + \phi = (2n - 1)\pi$$

n étant un nombre entier et $\phi \neq n\pi$

Gq étant la conductance de l'électrode Q, Gi étant la conductance de l'électrode I, ξ étant le rapport des tensions, φ étant la différence de phase géométrique et θ étant la différence de phase électrique.

2.  Module à ondes acoustiques de surface selon la revendication 1, caractérisé en ce que la différence de phase électrique θ est déterminée à une valeur autre que π/4 radian.

3.  Module à ondes acoustiques de surface selon la revendication 1 ou 2, caractérisé en ce que l'électrode Q et l'électrode I ont des conductances différentes l'une de l'autre.

4.  Module à ondes acoustiques de surface selon la revendication 1, caractérisé en ce que

    au moins un des transducteurs est un transducteur unidirectionnel ayant une combinaison de m paires d'électrodes Q et de k paires d'électrodes I avec un transducteur interdigité non-apodisant ou un transducteur unidirectionnel du type groupe ayant une pluralité de tels groupes de combinaisons, et

    les paires d'électrodes Q, les paires d'électrodes I et le déphaseur électrique ont une relation exprimée par :

    $$\xi = m/k$$

    et

    $$\theta - \phi = (2n - 1)\pi \text{ ou } \theta + \phi = (2n - 1)\pi$$

    n étant un nombre entier et $\phi \neq n\pi$

    m étant le nombre de paires d'électrodes Q, k étant le nombre de paires d'électrodes I, ξ étant le rapport des tensions, φ étant la différence de phase géométrique et θ étant la différence de phase électrique.

5.  Module à ondes acoustiques de surface selon la revendication 1, caractérisé en ce que

    au moins un des transducteurs est un transducteur unidirectionnel du type groupe ayant N groupes de combinaisons,

    les électrodes Q et/ou les électrodes I sont connectées en parallèle avec un déphaseur électrique (5, 5', 6, 6', 175) et en série les unes avec les autres,

    la conductance de l'électrode Q est Gq, la conductance de l'électrode I est Gi, la susceptance de l'électrode Q est Bq, et la susceptance de l'électrode I est Bi,

    la susceptance du déphaseur électrique (5, 5', 175) connecté à l'électrode Q est

    $$\sqrt{GqGi}\, (1 + 1/N)\sin\phi - Bq$$

    et la susceptance du déphaseur électrique (6, 6') connecté à l'électrode I est

    $$-\sqrt{GqGi}\, (1 - 1/N)\sin\phi - Bi$$

6.  Module à ondes acoustiques de surface selon la revendication 5, caractérisé en ce que

    la conductance Gq de l'électrode Q, la conductance Gi de l'électrode I, la susceptance Bq de l'électrode Q, la différence de phase géométrique φ et le nombre N de groupes sont en relation :

    $$\sqrt{GqGi}\, (1 + 1/N)\sin\phi - Bq = 0$$

et aucun déphaseur électrique n'est connecté aux électrodes Q.

7. Module à ondes acoustiques de surface selon la revendication 5, caractérisé en ce que

la conductance Gq de l'électrode Q, la conductance Gi de l'électrode I, la susceptance Bi de l'électrode I, la différence de phase géométrique $\phi$ et le nombre N des groupes sont en relation :

$$- \sqrt{GqGi}\ (1\text{-}1/N)\sin\phi\text{-Bi=}0$$

et aucun déphaseur électrique n'est connecté aux électrodes I.

8. Module à ondes acoustiques de surface selon la revendication 1, caractérisé en ce que

au moins un des transducteurs est un transducteur unidirectionnel du type groupe avec N groupes de combinaisons,

les électrodes Q et/ou les électrodes I sont connectées en série avec un déphaseur électrique (205, 205', 206, 206') d'un côté et de l'autre côté en parallèle les unes avec les autres par le déphaseur électrique,

la conductance de l'électrode Q est Gq, la conductance de l'électrode I est Gi, la susceptance de l'électrode Q est Bq et la susceptance de l'électrode I est Bi, et

la susceptance du déphaseur électrique (205, 205') connecté aux électrodes Q est

$$\frac{BiBqN^2+(N^2\text{-}1)GiGq\sin^2\phi}{-N^2Bi + \sqrt{GqGi}\ N(N+1)\sin\phi}$$

la susceptance du déphaseur électrique (206, 206') connecté aux électrodes I est

$$\frac{BiBqN^2+(N^2\text{-}1)GqGi\sin^2\phi}{-N^2Bq - \sqrt{GqGi}\ N(N\text{-}1)\sin\phi}$$

9. Module à ondes acoustiques de surface selon la revendication 8, caractérisé en ce que

la conductance Gq de l'électrode Q, la conductance Gi de l'électrode I, la susceptance Bi de l'électrode I, la différence de phase géométrique $\phi$ et le nombre N de groupes ont une relation étant

$$-N^2Bi\text{-} \sqrt{GqGi}\ N(N+1)\sin\phi\text{=}0$$

et aucun déphaseur électrique n'est connecté aux électrodes Q.

10. Module à ondes acoustiques de surface selon la revendication 8, caractérisé en ce que

la conductance Gq de l'électrode Q, la conductance Gi de l'électrode I, la susceptance Bq de l'électrode Q, la différence de phase géométrique $\phi$ et le nombre N de groupes sont en relation :

$$-N^2Bq\text{-} \sqrt{GqGi}\ N(N\text{-}1)\sin\phi\text{=}0$$

et aucun déphaseur électrique n'est connecté aux électrodes I.

11. Station pour un système de communication numérique caractérisé en ce qu'elle inclut un module à ondes acoustiques de surface selon une quelconque des revendications 1 à 10 utilisé pour le filtrage radiofréquence ou pour le filtrage d'une fréquence intermédiaire.

# FIG. 1

# FIG . 2

# FIG.3

1044

1046 PHASE SHIFTER

Vq        V₁

1041

REVERSE
DIRECTION
⇧

⇩

FORWARD
DIRECTION

31

32

33

1042

1043

Q ELECTRODE

MEANDER
ELECTRODE

I ELECTRODE

1047 PHASE SHIFTER

1045

# FIG. 4

# FIG. 5

# FIG. 6

# F I G. 7A

UNIT SECTION FOR
Q+ ELECTRODE

61　　　62　　　61

50　　　50　　　50

$Z = Zm$

$\theta = \dfrac{\pi}{4}$

$1 : rq$

$Z = Zo$

$\theta = \dfrac{\pi}{2}$

$1 : rq$

$Z = Zm$

$\theta = \dfrac{\pi}{4}$

$1 : rq$

# F I G. 7B

60

$Z = Zo = Zm$

$\theta = \pi$

$1 : rq$

# FIG. 8A

A PAIR OF Q ELECTRODE

35    36

60    60

1 : rq    1 : -rq

# FIG. 8B

70

71    Yq    72

73

# F I G. 9A

m PAIRS OF Q ELECTRODES

34

ONE PAIR OF Q ELECTRODES

70          70          70

$Y_q$      $Y_q$      $Y_q$

# F I G. 9B

80

82      $Y_Q$      82

83

FIG. 10A

FIG. 10B

FIG. 11A

FIG. 11B

## FIG. 12A

N GROUPS

ONE GROUP

Y     Y     Y

100     100     100

## FIG. 12B

114

$Y_N$

111     112

110

113

## FIG. 13

114 FOURTH PORT

128 I ELECTRODE CAPACITY

LOAD $Z_1 = 1$  125     126 LOAD $Z_2 = 1$

$Y_N$

111     112

120     127 Q ELECTRODE CAPACITY

115 THIRD PORT

# FIG.14

132   133

131

# FIG.15

# FIG. 16

EP 0 473 096 B1

FIG. 17

FIG.18

# FIG.19

EP 0 473 096 B1

# FIG.20

# FIG.21

# FIG. 22

# FIG. 23

# FIG. 24

# FIG.25

1261

1263

1262

# FIG.26

1263 POWER TERMINAL

1269

1264

1271

1261

1266

1267

1268

1270

1273

1265

1272

1262

# FIG. 27

1264

1603

1602

1601

# FIG. 28

1223

1226

1225

1229

1221    1222    1227    1224

# FIG. 29

EP 0 473 096 B1

# FIG. 30

# FIG. 31